# EUROPEAN PATENT APPLICATION

(11) **EP 4 418 839 A2**
(43) Date of publication of application: **21.08.2024**
(21) Application number: 24158180.0
(22) Date of filing: 16.02.2024
(51) Int. Cl.: H10K 59/122, H10K 59/123

(54) **LIGHT EMITTING DISPLAY DEVICE**

(30) Priority: 20.02.2023 KR 20230022139
(71) Applicant: Samsung Display Co., Ltd., Yongin-si, Gyeonggi-do 17113 (KR)
(72) Inventor: SHIN, Dong Hee, 17113 Yongin-si (KR); SON, Sun Kwun, 17113 Yongin-si (KR); NO, Sang Yong, 17113 Yongin-si (KR)
(74) Representative: Taor, Simon Edward William

(57) **Abstract**

A light emitting display device includes: a substrate (110); a driving element layer on the substrate and including a transistor and a planarization film (181) covering the transistor; a second electrode on the planarization film and including a contact opening; a separator (SEP) on the planarization film and has a reverse-tapered sidewall; a pixel defining layer (380) including a first opening (PO1) exposing a portion of the second electrode, a second opening (OP2) exposing a portion of the separator, and a third opening (OPcon) corresponding to the contact opening of the second electrode; and a first electrode on the pixel defining layer, wherein the first electrode is electrically connected to the transistor of the driving element layer through the contact opening of the second electrode and the third opening of the pixel defining layer.

## Description

### CROSS-REFERENCE TO RELATED APPLICATIONS

The present application claims priority to and benefits of Korean Patent Application No. 10-2023-0022139 filed February 20, 2023, in the Korean Intellectual Property Office.

### BACKGROUND

### 1. Field

Aspects of some embodiments of the present disclosure relate to a light emitting display device.

### 2. Description of Related Art

A display device is a device for displaying images, and includes a liquid crystal display (LCD), an organic light emitting diode (OLED) display, and the like. Display devices may be used in various electronic devices such as mobile phones, navigation devices, digital cameras, electronic books, portable game machines, various terminals, and the like.

Organic light emitting diode (OLED) displays may have self-luminance characteristics, and unlike liquid crystal displays (LCDs), it may not require a separate light source to reduce thickness and weight. In addition, organic light emitting diode (OLED) displays generalyl have high quality characteristics such as relatively low power consumption, high luminance, fast response speed, or the like.

The above information disclosed in this Background section is only for enhancement of understanding of the background and therefore the information discussed in this Background section does not necessarily constitute prior art.

### SUMMARY

Aspects of some embodiments include a light emitting display device including a separator that is located below a pixel defining layer and has a portion exposed by the pixel defining layer.

A light emitting display device according to some embodiments includes: a substrate; a driving element layer on the substrate and includes a transistor and a planarization film covering the transistor; a second electrode on the planarization film and includes a contact opening; a separator on the planarization film and has a reverse-tapered sidewall; a pixel defining layer including a first opening exposing a portion of the second electrode, a second opening exposing a portion of the separator, and a third opening corresponding to the contact opening of the second electrode; and a first electrode on the pixel defining layer. According to some embodiments, the first electrode is electrically connected to the transistor of the driving element layer through the contact opening of the second electrode and the third opening of the pixel defining layer.

According to some embodiments, the separator may include an outer portion and an inner portion, and the second opening of the pixel defining layer may expose at least a portion of the outer portion of the separator.

According to some embodiments, an edge of the first electrode may coincide with the outer portion exposed by the second opening on a plane.

According to some embodiments, all side surfaces of the inner portion may be covered by the pixel defining layer.

According to some embodiments, the inner portion may overlap the first electrode on a plane.

According to some embodiments, the separator may further include an additional portion, and the second opening of the pixel defining layer may expose at least a portion of the additional portion.

According to some embodiments, the light emitting display device may further include an additional electrode formed of the same material as the first electrode. According to some embodiments, some of edges of the additional electrode may coincide with the additional portion exposed by the second opening on a plane.

According to some embodiments, the rest of the edges of the additional electrode may coincide with a portion of the outer portion on a plane.

According to some embodiments, a central portion of the additional electrode excluding the edges may overlap the pixel defining layer on a plane.

According to some embodiments, both sidewalls of the additional portion may overlap the second opening.

A light emitting display device according to some embodiments includes: a substrate; a driving element layer on the substrate and includes a driving transistor and a planarization film covering the driving transistor; a second electrode on the planarization film and including a driving gate electrode overlapping opening overlapping a gate electrode of the driving transistor on a plane; a separator on the planarization film, having a reverse-tapered sidewall, and including an outer portion, an inner portion, and an additional portion; a pixel defining layer including a first opening exposing a portion of the second electrode and a second opening exposing at least portions of the outer portion and the additional portion of the separator; and a first electrode and an additional electrode at an upper potion of the pixel defining layer. An edge of the first electrode coincides with the outer portion exposed by the second opening on a plane.

According to some embodiments, some of edges of the additional electrode may coincide with the additional portion exposed by the second opening on a plane.

According to some embodiments, the rest of the edges of the additional electrode may coincide with a portion of the outer portion on a plane.

According to some embodiments, a central portion of the additional electrode excluding the edges may overlap the pixel defining layer on a plane.

According to some embodiments, both sidewalls of the additional portion may overlap the second opening.

According to some embodiments, the separator may include one or more additional portions connected to one outer portion.

According to some embodiments, an edge of the first electrode may coincide with the outer portion exposed by the second opening on a plane.

According to some embodiments, all side surfaces of the inner portion may be covered by the pixel defining layer, and the inner portion may overlap the first electrode on a plane.

According to some embodiments, the second electrode may further include a contact opening, the pixel defining layer may further include a third opening corresponding to the contact opening of the second electrode, and the first electrode may be electrically connected to the transistor of the driving element layer through the contact opening of the second electrode and the third opening of the pixel defining layer.

According to some embodiments, the driving gate electrode overlapping opening and the contact opening may be integrally formed at the second electrode.

According to an aspect, there is provided a light emitting display device as set out in claim 1. Additional features are set out in claims 2 to 8. According to an aspect, there is provided a light emitting display device as set out in claim 9. Additional features are set out in claims 10 to 15.

According to some embodiments of the present disclosure, a conductive layer that is stacked above or on a separator with the separator exposed by a pixel defining layer may be clearly separated based on the separator. The pixel defining layer may be located above or on the separator so that a light emitting layer provided by an inkjet process does not cross the pixel defining layer and is within a region divided by the pixel defining layer due to a hydrophobic property of an upper surface of the pixel defining layer. Thus, a defects in a light emitting display device may be prevented or reduced.

### BRIEF DESCRIPTION OF THE DRAWINGS

FIG. 1 is a circuit diagram of a pixel of a light emitting display device according to some embodiments.
FIG. 2 is a plan view of a display area of the light emitting display device device according to some embodiments.
FIGS. 3 to 5 are plan views separately illustrating a portion of FIG. 2 according to some embodiments.
FIG. 6 is a cross-sectional view showing a step of providing a light emitting layer by an inkjet method according to some embodiments.
FIG. 7 a cross-sectional view of the light emitting display device according to the embodiments of FIG. 2.
FIG. 8 is a circuit diagram of a pixel of an light emitting display device according to some embodiments.
FIG. 9 to FIG. 13 are plan views illustrating a display area of the light emitting display device according to a manufacturing sequence according to some embodiments.
FIG. 14 is a cross-sectional view of the light emitting display device according to the embodiments of FIGS. 9 to 13.

### DETAILED DESCRIPTION

Aspects of some embodiments of the present disclosure will be described more fully hereinafter with reference to the accompanying drawings, in which embodiments of the disclosure are shown. As those skilled in the art would realize, the described embodiments may be modified in various different ways, all without departing from the scope of embodiments according to the present disclosure.

In order to more clearly describe embodiments according to the present disclosure, parts or portions that are irrelevant to the description are omitted, and identical or similar constituent elements throughout the specification are denoted by the same reference numerals.

Further, in the drawings, the size and thickness of each element are arbitrarily illustrated for ease of description, and the present disclosure is not necessarily limited to those illustrated in the drawings. In the drawings, the thicknesses of layers, films, panels, regions, areas, etc., are exaggerated for clarity. In the drawings, for ease of description, the thicknesses of some layers and areas are exaggerated.

It will be understood that when an element such as a layer, film, region, area, substrate, plate, or constituent element is referred to as being "on" or "above" another element, it may be directly on the other element or intervening elements may also be present. In contrast, when an element is referred to as being "directly on" another element, there are no intervening elements present. Further, in the specification, the word "on" or "above" refers to an element be located on or below the object portion, and does not necessarily refer to the element be located on the upper side of the object portion based on a gravitational direction.

In addition, unless explicitly described to the contrary, the word "comprise" and variations such as "comprises" or "comprising" will be understood to imply the inclusion of stated elements but not the exclusion of any other elements.

Further, throughout the specification, the phrase "in a plan view" or "on a plane" means viewing a target portion from the top, and the phrase "in a cross-sectional view" or "on a cross-section" means viewing a cross-section formed by vertically cutting a target portion from the side.

In addition, throughout the specification, "connected" does not only mean when two or more elements are directly connected, but when two or more elements are indirectly connected through other elements, and when they are physically connected or electrically connected, and further, it may be referred to by different names depending on a position or function, and may also be referred to as a case in which respective parts that are substantially integrated are linked to each other.

In addition, throughout the specification, when it is said that an element such as a wire, layer, film, region, area, substrate, plate, or constituent element "is extended (or extends) in a first direction or second direction", this does not mean only a straight shape extending straight in the corresponding direction, but may mean a structure that substantially extends in the first direction or the second direction, is partially bent, has a zigzag structure, or extends while having a curved structure.

In addition, an electronic device (for example, a mobile phone, a TV, a monitor, a laptop computer, or the like) included in a display device, a display panel, or the like described in the specification, or an electronic device included in a display device, a display panel, or the like manufactured by a manufacturing method described in the specification is not excluded from the scope of the present specification.

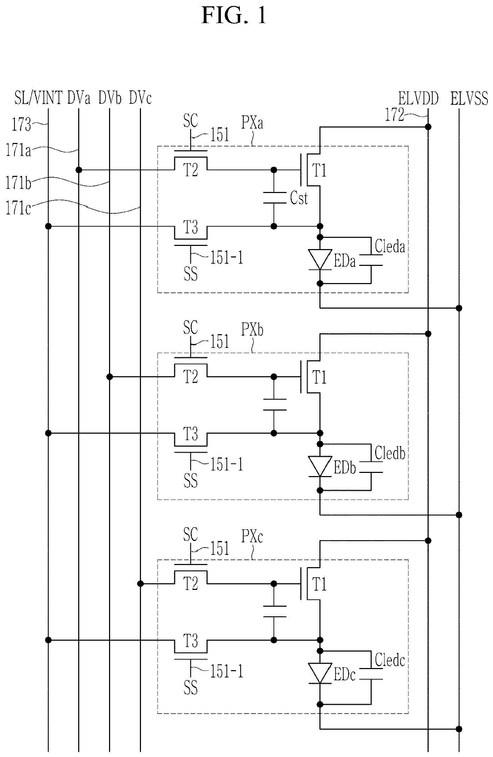

First, a circuit structure of a pixel that may be included in a light emitting display device according to some embodiments will be described with respect to FIG. 1.

FIG. 1 is a schematic view of the light emitting display device according to some embodiments.

FIG. 1 shows the circuit diagram of three pixels PXa, PXb, and PXc.

A plurality of pixels may include the first pixel PXa, the second pixel PXb, and the third pixel PXc. Each of the first pixel PXa, the second pixel PXb, and the third pixel PXc includes a plurality of transistors T1, T2, and T3, a storage capacitor Cst, and a light emitting element EDa, EDb, or EDc. Here, one pixel PXa, PXb, or PXc may be divided into the light emitting element EDa, EDb, or EDc and a pixel driving portion (or a pixel driver) PCa, PCb, or PCc. Referring to FIG. 1, the pixel driving portion PCa, PCb, or PCc may include the plurality of transistors T1, T2, and T3 and the storage capacitor Cst corresponding to portions of each pixel PXa, PXb, or PXc excluding the light emitting element EDa, EDb, or EDc. In addition, according to some embodiments, the pixel driving portion PCa, PCb, or PCc may further include a capacitor (hereinafter also referred to as a light emitting portion capacitor) Cleda, Cledb, or Cledc connected to both ends of the light emitting element EDa, EDb, or EDc. The light emitting portion capacitor Cleda, Cledb, or Cledc may not be included in the pixel driving portion, but may be included in light emitting element EDa, EDb, or EDc. Additinoally, according to some embodiments, the pixel driving portion PCa, PCb, or PCc may include additional components without departing from the scope of embodiments according to the present disclosure.

The plurality of transistors T1, T2, and T3 may be formed as one driving transistor (also referred to as a first transistor) T1 and two switching transistors T2 and T3, and the two switching transistors are divided into an input transistor (also referred to as a second transistor) T2 and an initialization transistor (also referred to as a third transistor) T3. Each transistor T1, T2, and T3 includes a gate electrode, a first electrode, and a second electrode, and also includes a semiconductor layer including a channel so that an electric current flows through the channel of the semiconductor layer or a flow of an electric current through the channel of the semiconductor layer is blocked according to a voltage of the gate electrode. Here, one of the first electrode and the second electrode may be a source electrode and the other of the first electrode and the second electrode may be a drain electrode according to a voltage applied to each transistor T1, T2, or T3.

The gate electrode of the driving transistor T1 is connected to one end of the storage capacitor Cst, and is also connected to a second electrode (an output side electrode) of the input transistor T2. In addition, the first electrode of the driving transistor T1 is connected to a driving voltage line 172 that transfers a first voltage (hereinafter also referred to as a driving voltage) ELVDD, and the second electrode of the driving transistor T1 is connected to an anode of the light emitting element EDa, EDb, or EDc, the other end of the storage capacitor Cst, the first electrode of the initialization transistor T3, and one end of the light emitting port capacitor Cleda, Cledb, or Cledc. The driving transistor T1 may receive a data voltage DVa, DVb, or DVc through the gate electrode according to a switching operation of the input transistor T2, and may supply a driving electric current to the light emitting element EDa, EDb, or EDc according to a voltage of the gate electrode. In this case, the storage capacitor Cst stores and maintains the voltage of the gate electrode of the driving transistor T1.

The gate electrode of the input transistor T2 is connected to a first scan signal line 151 transferring a first scan signal SC. The first electrode of the input transistor T2 is connected to a data line 171a, 171b, or 171c that transfers a data voltage DVa, DVb, or DVc, and the second electrode of the input transistor T2 is connected to one end of the storage capacitor Cst and the gate electrode of the driving transistor T1. A plurality of data lines 171a, 171b, and 171c respectively transfer different data voltages DVa, DVb, and DVc, and input transistors T2 of the pixels PXa, PXb, and PXc are connected to different data lines 171a, 171b, and 171c.

The gate electrode of the input transistor T2 of each pixel PXa, PXb, or PXc may be connected to the same first scan signal line 151 to receive the first scan signal SC of the same timing. Even if the input transistor T2 of each pixel PXa, PXb, or PXc is simultaneously turned on by the first scan signal SC of the same timing, the different data voltages DVa, DVb, and DVc are transferred to the gate electrode of the driving transistor T1 of the pixels PXa, PXb, and PXc and one end of the storage capacitor Cst through the different data lines 171a, 171b, and 171c.

FIG. 1 illustrates aspects of embodiments in which the gate electrode of the initialization transistor T3 receives a scan signal different from that of the gate electrode of the input transistor T2.

The gate electrode of the initialization transistor T3 is connected to a second scan signal line 151-1 that transfers a second scan signal SS. The first electrode of the initialization transistor T3 is connected to the other end of the storage capacitor Cst, the second electrode of the driving transistor T1, the anode of the light emitting element EDa, EDb, or EDc, and one end of the light emitting portion capacitor Cleda, Cledb, or Cledc, and the second electrode of the initialization transistor T3 is connected to an initialization voltage line 173 transferring an initialization voltage VINT. The initialization transistor T3 is turned on according to the second scan signal SS so that the initialization voltage VINT is transferred to the anode of the light emitting element EDa, EDb, or EDc, one end of the light emitting portion capacitor Cleda, Cledb, or Cledc, and the other end of the storage capacitor Cst. Thus, a voltage of the anode of the light emitting element EDa, EDb, or EDc is initialized.

The initialization voltage line 173 may perform an operation of sensing the voltage of the anode of the light emitting element EDa, EDb, or EDc before applying the initialization voltage VINT to serve as a sensing wire SL. The initialization voltage line 173 may check whether the voltage of the anode is maintained at a target voltage through the sensing operation. The sensing operation and an initialization operation of transferring the initialization voltage VINT may be separated in time and performed, and the initialization operation may be performed after the sensing operation is performed.

According to some embodiments as illustrated in FIG. 1, turn-on periods of the initialization transistor T3 and the input transistor T2 may be separated so that a writing operation performed by the input transistor T2 and the initialization operation and/or the sensing operation performed by the initialization transistor T3 may be performed at different timings from each other.

The one end of the storage capacitor Cst is connected to the gate electrode of the driving transistor T1 and the second electrode of the input transistor T2, and the other end of the storage capacitor Cst is connected to the first electrode of the initialization transistor T3, the second electrode of the driving transistor T1, the anode of the light emitting element EDa, EDb, or EDc, and one end of the light emitting portion capacitor Cleda, Cledb, or Cledc.

In the light emitting element EDa, EDb, or EDc, an output current of the driving transistor T1 is transferred to the anode, and a cathode receives a second voltage (hereinafter also referred to as a driving low voltage) ELVSS through a driving low voltage line 174. The light emitting element EDa, EDb, or EDc displays a gray level by emitting light according to the output current of the driving transistor T1.

In addition, the light emitting portion capacitor Cleda, Cledb, or Cledc is formed at both ends of the light emitting element EDa, EDb, or EDc so that a voltage at both ends of the light emitting element EDa, EDb, or EDc is kept constant. Thus, the light emitting element EDa, EDb, or EDc may display a constant luminance.

Hereinafter, further details of an operation of the pixel having the circuit shown in FIG. 1 will be briefly described.

FIG. 1 illustrates embodiments in which each transistor T1, T2, or T3 is an N-type transistor, and has a feature of being turned on when a high level voltage is applied to the gate electrode. However, according to some embodiments, all or some of the transistors T1, T2, and T3 may be a P-type transistor or an N-type transistor.

When a light emitting period ends, one frame begins. A high-level second scan signal SS is supplied to turn on the initialization transistor T3. When the initialization transistor T3 is turned on, the initialization operation and/or the sensing operation may be performed.

Embodiments in which both the initialization operation and the sensing operation are performed will be described in more detail below.

The sensing operation may be performed first before the initialization operation is performed. That is, when the initialization transistor T3 is turned on, the initialization voltage line 173 serves as the sensing wire SL to sense the voltage of the anode of the light emitting element EDa, EDb, or EDc. The initialization voltage line 173 may check whether the voltage of the anode is maintained at the target voltage through the sensing operation.

After that, the initialization operation may be performed, and initialization is performed by changing voltages of the other end of the storage capacitor Cst, the second electrode of the driving transistor T1, and the anode of the light emitting element EDa, EDb, or EDc to the initialization voltage VINT transferred from the initialization voltage line 173.

As described above, the sensing operation and the initialization operation of transferring the initialization voltage VINT may be separated in time and performed so that a minimum number of transistors is used. Thus, it may be possible to perform various operations of the pixel while reducing an area occupied by the pixel. As a result, resolution of the display panel may be improved.

The first scan signal SC is also changed to a high level along with the initialization operation or at a separate timing and the changed first scan signal SC is applied so tht the input transistor T2 is turned on and the writing operation is performed. That is, the data voltage DVa, DVb, or DVc from the data line 171a, 171b, or 171c are input to the gate electrode of the driving transistor T1 and the one end of the storage capacitor Cst through the turned-on input transistor T2 and the input voltage is stored.

The data voltage DVa, DVb, or DVc and the initialization voltage VINT are respectively applied to both ends of the storage capacitor Cst by the initialization operation and the writing operation. Even if the output current is generated from the driving transistor T1 in a state in which the initialization transistor T3 is turned on, the output current may be output to the outside through the initialization transistor T3 and the initialization voltage line 173 so that the output current is not input to the anode of the light emitting element EDa, EDb, or EDc. In addition, according to some embodiments, the first voltage ELVDD may be applied as a low level voltage or the second voltage ELVSS may be applied as a high level voltage during a writing period in which the first scan signal SC of a high level is supplied so that instances of a current flowing through the light emitting element EDa, EDb, or EDc may be prevented or reduced.

After that, when the first scan signal SC is changed to a low level, the driving transistor T1 generates and outputs the output current by a high-level first voltage ELVDD applied to the driving transistor T1 and the gate voltage of the driving transistor T1 stored in the storage capacitor Cst. The output current of the driving transistor T1 is input to the light emitting element EDa, EDb, or EDc so that the light emitting period in which the light emitting element EDa, EDb, or EDc emits light proceeds.

On the other hand, according to some embodiments, the first scan signal line 151 that transfers the first scan signal SC and the second scan signal line 151-1 that transfers the second scan signal SS may be formed as one scan signal line so that the same timing is received.

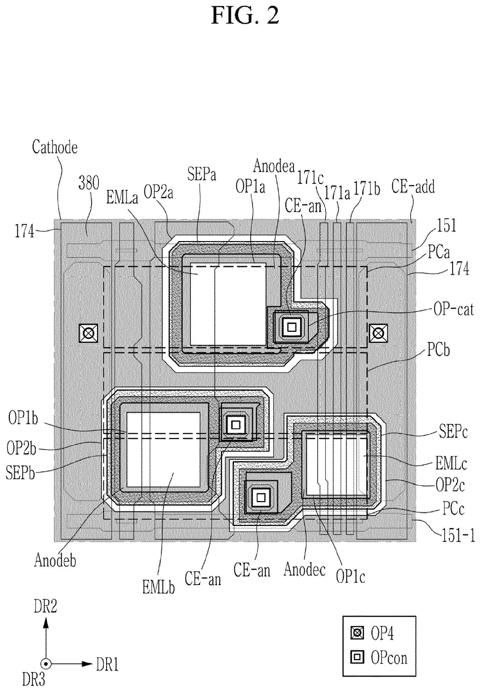

A planar structure and a cross-sectional structure of the light emitting display device including pixels having the above circuit structure will be described through FIGS. 2 to 7.

First, the planar structure will be described through FIGS. 2 to 5.

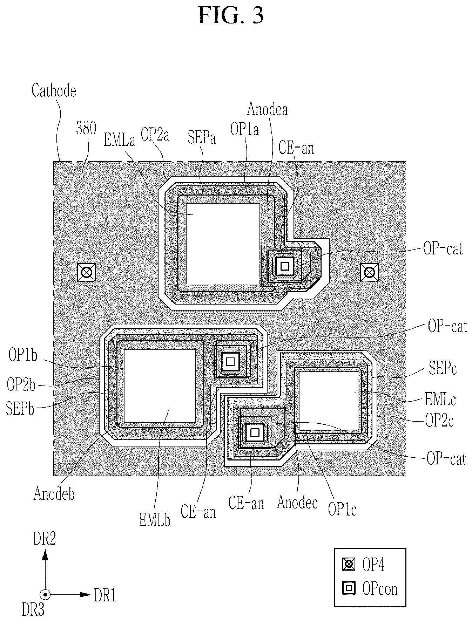

FIG. 2 is a plan view of a display area of the light emitting display device device according to some embodiments, and FIGS. 3 to 5 are plan views separately illustrating a portion of FIG. 2.

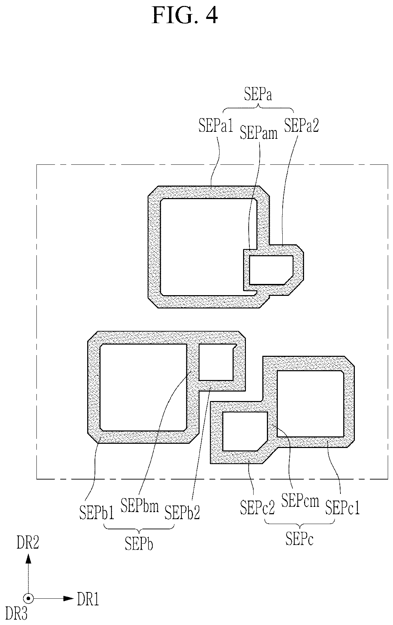

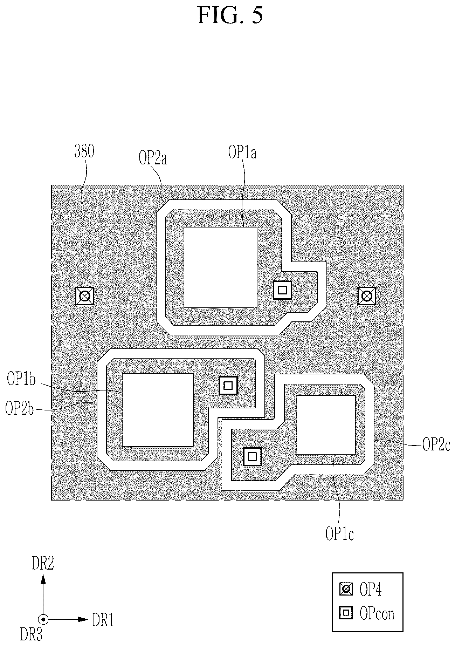

FIG. 2 shows an overall planar structure, FIG. 3 shows planar structures of a separator SEP, a pixel defining layer 380, and a light emitting layer EMLa, EMLb, or EMLc, FIG. 4 shows only the planar structure of the separator SEP, and FIG. 5 shows a structure of an opening formed at the pixel defining layer 380.

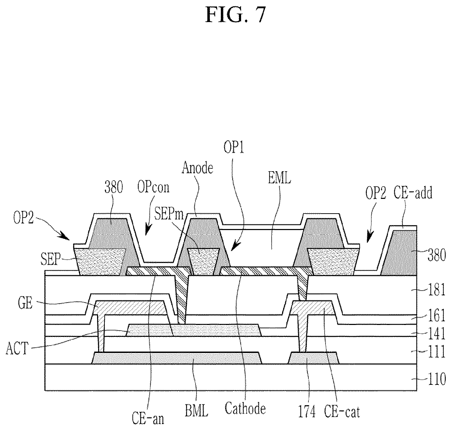

Referring to a cross-sectional view of FIG. 7, the light emitting display device may form the pixel driving portion PCa, PCb, or PCc included in the pixel at a lower portion thereof, and may form the separator SEP and the pixel defining layer 380 together with the light emitting element EDa, EDb, or EDc above or on the lower portion. Here, a layer corresponding to the pixel driving portion PCa, PCb, or PCc may be referred to as a driving element layer, and a layer located above or on the driving element layer may be referred to as a light emitting element layer.

In FIG. 2, only a region of the pixel driving portion PCa, PCb, or PCc included in the pixel is shown by a dotted line, and the cathode Cathode and each anode Anodea, Anodeb, or Anodec of the light emitting element EDa, EDb, or EDc connected to the pixel driving portion PCa, PCb, or PCc are shown. Here, each anode Anodea, Anodeb, or Anodec of the light emitting element EDa, EDb, or EDc is separated by the separator SEPa, SEPb, or SEPc. That is, in FIG. 2, each anode Anodea, Anodeb, or Anodec is located within the separator SEPa, SEPb, or SEPc.

On the other hand, the cathode Cathode according to some embodiments may be located below the separator SEPa, SEPb, or SEPc and the pixel defining layer 380 of FIG. 7. That is, referring to FIG. 7, an electrode located below the light emitting layer EML included in the light emitting element in the embodiments illustrated and described with respect to FIG. 2 is the cathode Cathode, and each anode Anodea, Anodeb, or Anodec is located on the light emitting layer.

In FIG. 2, the cathode Cathode has an opening (hereinafter also referred to as a contact opening (or an opening for a contact)) OP-cat, and the cathode Cathode is formed over an entire region except for the opening OP-cat. Each anode Anodea, Anodeb, or Anodec located on the light emitting layer receives a current from the pixel driving portion PCa, PCb, or PCc located below the pixel defining layer 380 through the opening OP-cat of the cathode Cathode.

In addition, In FIG. 2, the pixel defining layer 380 includes openings OP1a, OP1b, and OP1c overlapping the light emitting layers EMLa, EMLb, and EMLc, and openings OP2a, OP2b, and OP2c overlapping at least a portion of the separators SEPa, SEPb, and SEPc. In addition, the pixel defining layer 380 may include an opening (hereinafter also referred to as an opening for anode connection or a third opening) OPcon for connecting each anode Anodea, Anodeb, or Anodec and the pixel driving portion PCa, PCb, or PCc. In addition, the pixel defining layer 380 may be formed of the same material as the anode Anodea, Anodeb, or Anodec, and may further include an opening OP4 for applying the same voltage as a voltage applied to the cathode Cathode to an auxiliary electrode Cathode-add located outside the separator SEPa, SEPb, or SEPc. Here, the separators SEPa, SEPb, and SEPc may be located below the pixel defining layer 380, and may at least partially overlap the openings OP2a, OP2b, and OP2c located at the pixel defining layer 380. Openings OP1 and OPcon may be openings located at the pixel defining layer 380 and an insulating film located below the pixel defining layer 380.

Referring to FIG. 2, the layer corresponding to the pixel driving portion PCa, PCb, or PCc will be described in detail, focusing on a structure of the driving element layer.

FIG. 2 shows a portion of the display area, and one pixel includes the light emitting element and he pixel driving portion. FIG. 2 shows the anode Anodea, Anodeb, or Anodec, the light emitting layer EMLa, EMLb, or EMLc, the cathode Cathode, the separator SEPa, SEPb, or SEPc, and the pixel driving portion PCa, PCb, or PCc. Here, the anode Anodea, Anodeb, or Anodec, the light emitting layer EMLa, EMLb, or EMLc, and the cathode Cathode may be combined to form the light emitting element, and the light emitting element and the pixel driving portion PCa, PCb, or PCc may be combined to form the pixel. In addition, in FIG. 2, the light emitting layer EMLa, EMLb, or EMLc may be a light emitting layer located within an opening located at the pixel defining layer 380 of FIG. 7, and the light emitting layer EMLa, EMLb, or EMLc located within the opening of the pixel defining layer 380 of FIG. 7 may be referred to as a light emitting region.

In FIG. 2, a total of three pixel driving portions PCa, PCb, and PCc adjacent to each other are schematically shown by a dotted line.

Each of the three pixel driving portions PCa, PCb, and PCc located in FIG. 2 may have a structure extending in a first direction DR1, and the three pixel driving portions PCa, PCb, and PCc may be pixel driving portions corresponds to pixels displaying three primary colors of light. The pixel driving portion PCa, PCb, or PCc may have various structures, and may have the same circuit structure as that of FIG. 1 according to some embodiments.

FIG. 2 additionally shows some of wires connected to the pixel driving portions PCa, PCb, and PCc. FIG. 2 shows the first scan signal line 151 and the second scan signal line 151-1 extending in the first direction DR1. In addition, FIG. 2 shows the data line 171a, 171b, or 171c, the driving voltage line 172, the initialization voltage line 173, and the driving low voltage line (hereinafter also referred to as a second driving voltage line) 174 extending in a second direction DR2.

Here, the pixel driving portions PCa, PCb, and PCc may be commonly connected to the first scan signal line 151, the second scan signal line 151-1, the driving voltage line 172, the initialization voltage line 173, and the driving low voltage line 174. In addition, the first driving portion PCa may be connected to a first data line 171a, the second driving portion PCb may be connected to a second data line 171b, and the third driving portion PCc may be connected to a third data line 171c.

The pixel driving portion PCa, PCb, or PCc may correspond to each of three plane regions divided by the first scan signal line 151, the second scan signal line 151-1, and the driving low voltage line 174. According to some embodiments, the first scan signal line 151 and the second scan signal line 151-1 may be formed as one scan line.

Referring to FIGS. 2 and 3, the first driving portion PCa is connected to the first anode Anodea through the opening (the opening for anode connection or the third opening) OPcon and the opening OP-cat located at the cathode Cathode, the second driving portion PCb is connected to the second anode Anodeb through the opening OPcon and the opening OP-cat located at the cathode Cathode, and the third driving portion PCc is connected to the third anode Anodec through the opening OPcon and the opening OP-cat located at the cathode Cathode.

A first light emitting element may include the first anode Anodea, the first light emitting layer EMLa, and the cathode Cathode, a second light emitting element may include the second anode Anodeb, the second light emitting layer EMLb, and the cathode Cathode, and a third light emitting element may include the third anode Anodec, the third light emitting layer EMLc, and the cathode Cathode.

The cathode Cathode may be formed over an entire display area except for the opening OP-cat. On the other hand, the cathode Cathode may be connected to the driving low voltage line 174 located below the cathode Cathode to receive the second voltage ELVSS.

The separator SEPa, SEPb, or SEPc and the pixel defining layer 380 are located above or on the cathode Cathode. For clarity of illustration and description, FIG. 4 shows only the separators SEPa, SEPb, and SEPc, and FIG. 5 shows only the opening located at the pixel defining layer 380.

A structure of the separator SEPa, SEPb, or SEPc is described in detail with reference to FIGS. 3 and 4.

Referring to FIG. 7, the separator SEPa, SEPb, or SEPc may have a structure having a reverse-tapered sidewall. Each of the separators SEPa, SEPb, and SEPc may form a closed curved line on a plane, and the anode may be separated based on the separator SEPa, SEPb, or SEPc. Each of the separators SEPa, SEPb, and SEPc may be separated and located at a distance (e.g., a set or predetermined distance) from each other, but according to some embodiments, at least portions of the separators SEPa, SEPb, and SEPc may be formed in a structure that is shared with each other. Each of the separators SEPa, SEPb, and SEPc may further include an inner portion SEPam, SEPbm, or SEPcm crossing to separate a region divided (or partitioned) by an outer portion SEPa1, SEPa2, SEPb1, SEPb2, SEPc1, or SEPc2 into two portions. The inner portion SEPam, SEPbm, or SEPcm divides a region divided by one separator SEPa, SEPb, or SEPc into a first region (hereinafter also referred to as a light emitting region) in which the light emitting layer EMLa, EMLb, or EMLc are arranged to correspond to the light emitting region and a second region (hereinafter also referred to as a contact region) corresponding to the opening OPcon of the pixel defining layer 380 for connecting an upper anode Anodea, Anodeb, or Anodec to the pixel driving portion PCa, PCb, or PCc. Here, the first region may correspond to the opening OP1a, OP1b, or OP1c of the pixel defining layer 380.

Referring to FIG. 4, the first separator SEPa may be divided into the first outer portion SEPa1 of the first region, the second outer portion SEPa2 of the second region, and the inner portion SEPam located between the first region and the second region. The first anode Anodea is located at a region (that is, the first region and the second region) divided into the first outer portion SEPa1 and the second outer portion SEPa2 of the first separator SEPa on a plane. The first light emitting layer EMLa is located inside the first region of the first separator SEPa on a plane. The first anode Anodea and the cathode Cathode located below the first light emitting layer EMLa constitute the first light emitting element. The first anode Anodea of the first light emitting element may be electrically connected to the first pixel driving portion PCa through the opening OP-cat located at the cathode Cathode, and may receive a current from the first pixel driving portion PCa.

The second separator SEPb may be divided into the first outer portion SEPb1 of the first region, the second outer portion SEPb2 of the second region, and the inner portion SEPbm located between the first region and the second region. The second anode Anodeb is located at a region (that is, the first region and the second region) divided into the first outer portion SEPb1 and the second outer portion SEPb2 of the second separator SEPb on a plane. The second light emitting layer EMLb is located inside the first region of the second separator SEPb on a plane. The second anode Anodeb and the cathode Cathode located below the second light emitting layer EMLb constitute the second light emitting element. The second anode Anodeb of the second light emitting element may be electrically connected to the second driving portion PCb through the opening OP-cat located at the cathode Cathode, and may receive a current from the second driving portion PCb.

The third separator SEPc may be divided into the first outer portion SEPc1 of the first region, the second outer portion SEPc2 of the second region, and the inner portion SEPcm located between the first region and the second region. The third anode Anodec is located at a region (that is, the first region and the second region) divided into the first outer portion SEPc1 and the second outer portion SEPc2 of the third separator SEPc on a plane. The third light emitting layer EMLc is located inside the first region of the third separator SEPc on a plane. The third anode Anodec and the cathode Cathode located below the third light emitting layer EMLc constitute the third light emitting element. The third anode Anodec of the third light emitting element may be electrically connected to the third driving portion PCc through the opening OP-cat located at the cathode Cathode, and may receive a current from the third driving portion PCc.

Referring to FIGS. 2 and 3, the pixel driving portion PCa, PCb, or PCc are connected to the anode Anodea, Anodeb, or Anodec through the opening OPcon of the pixel defining layer 380 within the opening OP-cat located at the cathode Cathode on a plane. A portion where the anode Anodea, Anodeb, or Anodec and the pixel driving portion PCa, PCb, or PCc are electrically connected may correspond to the second region of the separator SEPa, SEPb, or SEPc.

The auxiliary electrode Cathode-add that is formed of the same material as the anode Anodea, Anodeb, or Anodec but receives the second voltage ELVSS to receive the same voltage as a voltage of the cathode may be located outside the separators SEPa, SEPb, and SEPc. Here, the auxiliary electrode Cathode-add may be connected to the cathode Cathode through the opening OP4 located at the pixel defining layer 380, and as a result, it may be connected to the driving low voltage line 174 to receive the second voltage ELVSS. On the other hand, according to some embodiments, another voltage may be applied to the auxiliary electrode cathode-add or the auxiliary electrode cathode-add may be floating.

Hereinafter, a structure of the pixel defining layer 380 will be described in detail with reference to FIGS. 3 and 5.

FIG. 2, FIG. 3, and FIG. 5 show the opening located at the pixel defining layer 380, and the pixel defining layer 380 is located outside the opening of the pixel defining layer 380.

Specifically, the pixel defining layer 380 includes the first opening (hereinafter also referred to as a light-emitting region opening) OP1a, OP1b, or OP1c, the second opening (also referred to as an opening for exposing the separator) OP2a, OP2b, or OP2c, the third opening (also referred to as an opening for connecting the anode) OPcon, and a fourth opening (also referred to as an opening for connecting a voltage) OP4.

Referring to FIG. 5, the first opening OP1a, OP1b, or OP1c is an opening corresponding to the light emitting layer EMLa, EMLb, or EMLc, and is an opening corresponding to the light emitting element or the light emitting region. The first openings OP1a, OP1b, and OP1c may have a different size for each color, and may have a planar shape of a rectangle, a polygon, a circle, or an oval, or a planar shape with chamfered corners.

The second openings OP2a, OP2b, and OP2c form a closed curved line and overlap at least one portions of the separators SEPa, SEPb, and SEPc to expose at least one portions of the separators SEPa, SEPb, and SEPc. One side of the separator SEPa, SEPb, or SEPc having a reverse taper structure may be exposed by the second opening OP2a, OP2b, or OP2c, and a layer located at an upper portion of the separator SEPa, SEPb, or SEPc may be separated by the exposed side of the separator SEPa, SEPb, or SEPc.

Specifically, the second opening OP2a, OP2b, or OP2c do not overlap the inner portion SEPam, SEPbm, or SEPcm formed across the separator SEPa, SEPb, or SEPc. That is, the inner portion SEPam, SEPbm, or SEPcm of the separator SEPa, SEPb, or SEPc is covered with the pixel defining layer 380.

In addition, referring to FIG. 3, the second opening OP2a, OP2b, or OP2c overlaps an outer side surface (or an outer surface) of the separator SEPa, SEPb, or SEPc, so that it is formed along the outer side surface of the separator SEPa, SEPb, or SEPc and the outer side surface of the separator SEPa, SEPb, or SEPc is exposed by the second opening OP2a, OP2b, or OP2c.

According to an overlapping structure of the second opening OP2a, OP2b, or OP2c and the separator SEPa, SEPb, or SEPc of the pixel defining layer 380, the anodes Anodea, Anodeb, and Anodec located above or on the separators SEPa, SEPb, and SEPc and the pixel defining layer 380 are separated based on outer side surfaces of the separators SEPa, SEPb, and SEPc. In addition, the anodes Anodea, Anodeb, and Anodec located above or on the separators SEPa, SEPb, and SEPc are not separated by the inner portions SEPam, SEPbm, and SEPcm of the separators SEPa, SEPb, and SEPc covered by the pixel defining layer 380 and inner side surfaces (or inner surfaces) of the separators SEPa, SEPb, and SEPc. Since the inner portions SEPam, SEPbm, and SEPcm of the separators SEPa, SEPb, and SEPc are covered with the pixel defining layer 380, the anodes Anodea, Anodeb, and Anodec located above or on the separators SEPa, SEPb, and SEPc are integrally formed without being separated into the first and second regions.

An edge of the anode Anodea, Anodeb, or Anodec may coincide with the outer portion SEPa1, SEPa2, SEPb1, SEPb2, SEPc1, or SEPc2 exposed by the second opening OP2 of the pixel defining layer 380 on a plane.

Referring to FIG. 5, the third opening OPcon may be an opening for connecting the anode Anodea, Anodeb, or Anodec and the pixel driving portion PCa, PCb, or PCc, and may include an opening located at the pixel defining layer 380 and an insulating film located at a lower portion of the pixel defining layer 380. Referring to FIGS. 2 and 3, the pixel driving portion PCa, PCb, or PCc are connected to the anode Anodea, Anodeb, or Anodec through the opening OPcon of the pixel defining layer 380 within the opening OP-cat located at the cathode Cathode on a plane. A portion where the anode Anodea, Anodeb, or Anodec and the pixel driving portion PCa, PCb, or PCc are electrically connected may correspond to the second region of the separator SEPa, SEPb, or SEPc.

The fourth opening OP4 is an opening that connects the auxiliary electrode Cathode-add and the cathode Cathode, and allows the driving low voltage ELVSS applied to the cathode Cathode to be transferred to the auxiliary electrode Cathode-add formed of the same material as the anode Anodea, Anodeb, or Anodec. On the other hand, according to some embodiments, another voltage may be applied to the auxiliary electrode cathode-add or the auxiliary electrode cathode-add may be floating.

According to the above structure, the separator SEPa, SEPb, or SEPc is covered by the pixel defining layer 380 except for some outer side surfaces of the separator SEPa, SEPb, or SEPc. In this case, the pixel defining layer 380 may be treated so that an upper surface of the pixel defining layer 380 has a hydrophobic property and a side surface of the pixel defining layer 380 has a hydrophilic property in order to apply an inkjet process to the pixel defining layer 380.

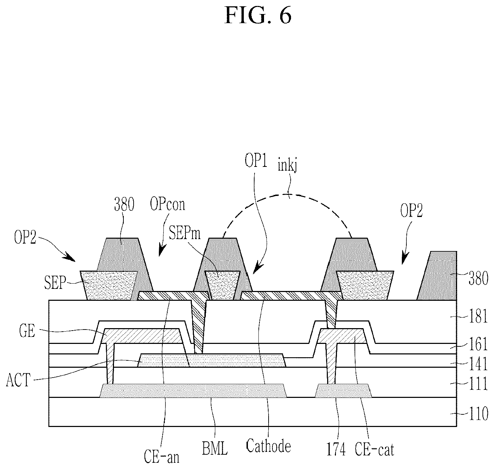

According to the above structure, the light emitting layer EMLa, EMLb, or EMLc may be formed by an inkjet method that will be described in detail with reference to FIG. 6.

FIG. 6 is a cross-sectional view showing a step of providing the light emitting layer by the inkjet method.

The upper surface of the pixel defining layer 380 located at an upper portion of the separator SEPa, SEPb, or SEPc has the hydrophobic property, and the side surface of the pixel defining layer 380 has the hydrophilic property. Specifically, after the pixel defining layer 380 is formed using a negative type organic material, the uppe surface of the pixel defining layer 380 is made hydrophobic through an exposure process. After that, the side surface of the pixel defining layer 380 may be made hydrophilic through a developing process. Here, since the pixel defining layer 380 uses the negative type organic material, it may have a characteristic in which a portion covered by a mask is removed.

After that, when a solution is sprayed on the first region corresponding to the light emitting region through the inkjet process in order to form each light emitting layer EMLa, EMLb, or EMLc, the upper surface of the pixel defining layer 380 may have the hydrophobic property. Thus, as shown by a dotted line in FIG. 6, the solution inkj may have a structure in which the solution inkj does not cross the upper surface of the pixel defining layer 380. Sufficient solution may be provided through the process to form each light emitting layer EMLa, EMLb, or EMLc so that each light emitting layer EMLa, EMLb, or EMLc is formed thicker than a certain thickness. Thus, a characteristic and a lifespan of each light emitting layer EMLa, EMLb, or EMLc may be sufficiently secured.

According to some embodiments, the pixel defining layer 380 is formed at the upper portion of the separator SEPa, SEPb, or SEPc for the inkjet process as described above. If the separator SEPa, SEPb, or SEPc is located at an upper portion of the pixel defining layer 380, even if the pixel defining layer 380 is treated so that the upper surface of the pixel defining layer 380 has the hydrophobic property and the side surface of the pixel defining layer 380 has the hydrophilic property, a problem in which the upper surface of the pixel defining layer 380 does not have the hydrophobic property so that the solution overflows, may occur. Particularly, referring to FIGS. 2 to 6, there is no need to utilize the separator that separates the anode between the first region corresponding to the light emitting region and the second region that is the contact region, so that the solution may easily pass from the first region to the second region.

However, if the pixel defining layer 380 is formed at the upper portion of the separator SEPa, SEPb, or SEPc as in the present embodiments, the inkjet process is possible in a state in which the upper surface of the pixel-defining layer 380 remains hydrophobic, so that the solution does not pass to the second region.

When the light emitting layer EMLa, EMLb, or EMLc are formed by the inkjet method as described above and then a conductive material for the anode is stacked on the light emitting layer EMLa, EMLb, or EMLc, each anode Anodea, Anodeb, or Anodec and the auxiliary electrode Cathode-add are formed due to an outer sidewall of an exposed separator SEPa, SEPb, or SEPc.

A stacking structure of the light emitting display device will be described with reference to FIG. 7.

FIG. 7 a cross-sectional view of the light emitting display device according to the embodiments of FIG. 2.

In a cross-sectional structure of FIG. 7, the light emitting element may correspond to the light emitting layer EML located within the first opening OP1 of the pixel defining layer 380, and the first opening OP1 of the pixel defining layer 380 is also referred to as the light emitting region.

FIG. 7 shows one light emitting region (that is, one light emitting layer EML located within the first opening OP1 of the pixel defining layer 380), and FIG. 7 shows a path through which a transistor current of the pixel driving portion PCa, PCb, and PCc is transferred to the anode Anode located at an upper portion of the light emitting layer EML through the opening OPcon and the separator SEP located below the pixel defining layer 380.

In the cross-sectional view of FIG. 7, a layer corresponding to the cathode Cathode, the separator SEP, the pixel defining layer 380, the light emitting layer EML, and the anode Anode may be also referred to as the light emitting element layer, and a planarization film 181 located below the light emitting element layer (that is, below the cathode Cathode) and a conductive layer, a semiconductor layer, and an insulating layer constituting the transistor and the capacitor and located below the planarization film 181 may be also referred to as the driving element layer.

In FIG. 7, the structure of the driving element layer is briefly shown so tht only one transistor is briefly shown, and a brief description of the structure of the driving element layer from a substrate 110 to the planarization film 181 is as follows.

The substrate 110 may include a rigid material such as glass or the like that does not bend, or may include a flexible material such as plastic or polyimide that may bend. The flexible substrate may have a structure in which a double-layered structure including polyimide and a barrier layer formed of an inorganic insulating material on the polyimide is repeatedly formed.

A lower shielding layer BML including a metal may be located on the substrate 110 so that the lower shielding layer BML overlaps one channel of the transistor located at the pixel driving portion PCa, PCb, or PCc included in the pixel on a plane. According to some embodiments, as illustrated in FIG. 7, the driving low voltage line 174 to which the second voltage ELVSS is applied is located at the same layer as the lower shielding layer BML. According to some embodiments, the lower shielding layer BML may be omitted, and in this case, the driving low voltage line 174 may be located at another conductive layer.

The substrate 110, the lower shielding layer BML, and the driving low voltage line 174 are covered by a buffer layer 111. The buffer layer 111 serves to block penetration of an impurity element into the semiconductor layer ACT, and may be an inorganic insulating film including a silicon oxide (SiOx), a silicon nitride (SiNx), a silicon oxynitride (SiOxNy), or the like.

The semiconductor layer ACT formed of a silicon semiconductor (e.g., a polycrystalline semiconductor) or an oxide semiconductor is located on the buffer layer 111. The semiconductor layer ACT may be a semiconductor layer located at the pixel driving portion PCa, PCb, and PCc included in the pixel, and may include the channel of the transistor including the driving transistor and a first region and a second region located on both sides of the channel. Here, the channel of the transistor may be a portion of the semiconductor layer ACT that overlaps a gate electrode GE, and the first region and the second region are portions of the semiconductor layer ACT that do not overlap the gate electrode GE. One of the first region and the second region may be a source region, and the other of the first electrode and the second electrode may be a drain region. That is, the first region and the second region located at both sides of the channel of the semiconductor layer ACT may be not covered by the gate electrode GE so that the first region and the second region have a conductive layer characteristic by plasma treatment or doping to serve as the first and second electrodes of the transistor.

A gate insulating film 141 may be located on the semiconductor layer ACT. The first gate insulating film 141 may be an inorganic insulating film including a silicon oxide (SiOx), a silicon nitride (SiNx), a silicon oxynitride (SiOxNy), or the like.

A first gate conductive layer including the gate electrode GE of the transistor located at the pixel driving portion PCa, PCb, or PCc may be located on the gate insulating film 141. The first gate conductive layer may include a scan line in addition to the gate electrode GE of the transistor located at the pixel driving portion PCa, PCb, or PCc. On the other hand, the first gate conductive layer may include one electrode of one capacitor located at the pixel driving portion PCa, PCb, or PCc. In addition, FIG. 7 may include an auxiliary electrode CE-cat connecting the driving low voltage line 174 and the cathode Cathode, and the auxiliary electrode CE-cat may be formed as the first gate conductive layer. The first gate conductive layer may include a metal such as aluminum (Al), copper (Cu), molybdenum (Mo), titanium (Ti), or the like, or a metal alloy, and may include a single layer or multiple layers.

After the first gate conductive layer is formed, a plasma treatment or doping process may be performed on the formed first gate conductive layer to make an exposed region of the semiconductor layer conductive. That is, the semiconductor layer ACT covered by the gate electrode GE may not be conductive, and a portion of the semiconductor layer ACT not covered by the gate electrode GE may have the same characteristic as that of a conductive layer.

An interlayer insulating film 161 may be located on the first gate conductive layer and the gate insulating film 141. The interlayer insulating film 161 may include an inorganic insulating film (or an inorganic insulating material) including a silicon oxide SiOₓ), a silicon nitride (SiNₓ), a silicon oxynitride (SiOₓN_{y}), or the like, and according to some embodiments, the inorganic insulating film may be thickly formed. In addition, according to some embodiments, the interlayer insulating film 161 may be formed of an organic insulating film, and may include at least one material selected from the group consisting of polyimide, polyamide, acrylic resin, benzocyclobutene, and phenol resin.

The planarization film 181 is located on the interlayer insulating film 161. The planarization film 181 includes the opening OPcon for connecting the pixel driving portion PCa, PCb, or PCc and the anode Anodea, Anodeb, or Anodec. FIG. 7 has a structure in which a portion of the semiconductor layer ACT included in the transistor is electrically connected to the anode Anodea, Anodeb, or Anodec through a connection electrode CE-an formed subsequently. However, according to some embodiments, an additional connecting electrode may be included between the connection electrode CE-an and the semiconductor layer ACT.

In addition, in FIG. 7, an opening for electrically connecting the driving low voltage line 174 and the cathode Cathode through the auxiliary electrode CE-cat is also formed at the buffer layer 111, the gate insulating film 141, the interlayer insulating film 161, and the planarization film 181 included in the driving element layer. The planarization film 181 may be formed of an organic insulating film, and may include at least one material selected from the group consisting of polyimide, polyamide, acrylic resin, benzocyclobutene, and phenol resin.

Accordign to some embodiments, a data conductive layer including a connection electrode may be located between the interlayer insulating film 161 and the planarization film 181.

The structure of the driving element layer has been described above, and a structure of the light emitting element layer will be described in detail below.

A first electrode layer including the cathode Cathode and the anode connection electrode CE-an is formed on the planarization film 181. The anode connection electrode CE-an is located within the opening OP-cat of the cathode Cathode to be electrically separated from the cathode Cathode. A portion of the cathode Cathode may overlap the light emitting layer EML located within the first opening OP1 of the pixel defining layer 380 to overlap the light emitting region and constitute the light emitting element. The anode connection electrode CE-an is electrically connected to the anode Anode in a subsequent process.

The first electrode layer may be formed of a single layer including a transparent conductive oxide film or a metal material, or multiple layers including the same. The transparent conductive oxide film may include indium tin oxide (ITO), poly-ITO, indium zinc oxide (IZO), indium gallium zinc oxide (IGZO), indium tin zinc oxide (ITZO), or the like. The metal material may include silver (Ag), molybdenum (Mo), copper (Cu), gold (Au), aluminum (Al), or the like.

The separator SEP may be located on the planarization film 181, and at least a portion of the separator SEP may overlap a portion of the first electrode layer.

The separator SEP may have a sidewall with a reverse-tapered structure, and may be divided into a first outer portion (SEP1) of the first region located outside the cathode Cathode, a second outer portion (SEP2) of the second region located outside the anode connection electrode CE-an, and an inner portion SEPm located between the cathode Cathode and the anode connection electrode CE-an. The anode Anode is separated by the first outer portion (SEP1) of the first region and the second outer portion (SEP2) of the second region, and the inner portion SEPm overlaps the anode Anode and does not separate the anode Anode. The first region may be a region between the first outer portion (SEP1) and the inner portion SEPm, and the second region may be a region between the second outer portion (SEP2) and the inner portion SEPm.

The pixel defining layer 380 including the openings OP1, OP2, and OPcon is formed on the planarization film 181, the first electrode layer, and the separator SEP.

The first opening OP1 of the pixel defining layer 380 may correspond to the light emitting element and/or the light emitting region, and may correspond to the first region divided by the separator SEP. The pixel defining layer 380 dividing the first opening OP1 of the pixel defining layer 380 may overlap the first outer portion (SEP1) and the inner portion SEPm of the separator SEP.

The first opening OP1 of the pixel defining layer 380 may expose a portion of the cathode Cathode, and the light emitting layer EML may be located at the first opening OP1 of the pixel defining layer 380. Here, the light emitting layer EML may be formed by the inkjet method.

The second opening OP2 of the pixel defining layer 380 may be an opening formed along the first outer portion (SEP1) and the second outer portion (SEP2) of the separator SEP, and may expose tapered side surfaces of the first outer portion (SEP1) and the second outer portion (SEP2) so tht the anode Anode formed subsequently is separated based on the separator SEP. Here, the pixel defining layer 380 dividing the second opening OP2 of the pixel defining layer 380 may overlap the first outer portion (SEP1) and the second outer portion (SEP2) of the separator SEP, and may expose an outer sidewall of the separator SEP.

The third opening OPcon of the pixel defining layer 380 may be a portion where the anode connection electrode CE-an and the anode Anode are connected, and may correspond to the second region divided by the separator SEP. The pixel defining layer 380 dividing the third opening OPcon of the pixel defining layer 380 may overlap the second outer portion (SEP2) and the inner portion SEPm of the separator SEP. The third opening OPcon of the pixel defining layer 380 may be electrically connected to the anode Anode formed subsequently by exposing a portion of the anode connection electrode CE-an.

The light emitting layer EML, the anode Anode, and the auxiliary electrode Cathode-add may be located above or on the planarization film 181, an exposed cathode Cathode, an exposed anode connection electrode CE-an, an exposed separator SEP, and the pixel defining layer 380.

The light emitting layer EML may be located within the first opening OP1 of the pixel defining layer 380, and a second functional layer is located between the cathode Cathode and the light emitting layer EML. In addition, a first functional layer may be located above or on the light emitting layer EML. Here, the first functional layer may include a hole injection layer and/or a hole transport layer, and the second functional layer may include an electron transport layer and/or an electron injection layer. According to some embodiments, the first functional layer and the second functional layer may be located above or on the pixel defining layer 380, and both sides of the first functional layer and the second functional layer may be separated from each other based on the exposed separator SEP.

A second electrode layer including the anode Anode is formed on the light emitting layer EML, the pixel defining layer 380, and the openings OP1, OP2, and OPcon.

The anode Anode is separated by the exposed separator SEP, the anode Anode is also formed at the pixel defining layer 380 and the openings OP1 and OPcon, and a portion of the anode Anode is also located on the light emitting layer EML.

On the other hand, the second electrode layer may further include the auxiliary electrode Cathode-add located outside the first region and the second region divided by the pixel defining layer 380, the second opening OP2, and the separator SEP. The auxiliary electrode Cathode-add is connected to the cathode Cathode by the fourth opening OP4 to receive the second voltage ELVSS.

If the second electrode layer including the anode Anode and the auxiliary electrode Cathode-add is stacked without a separate mask, an automatically separated structure is formed by a portion (the first outer portion (SEP1) and the second outer portion (SEP2)) of the separator SEP not covered by the pixel defining layer 380. That is, the second electrode layer formed at an upper portion of the separator SEP is separated into the anode Anode and the electrode auxiliary Cathode-add without a separate etching process by a reverse-tapered sidewall of the exposed separator SEP.

Referring to FIG. 7, a portion serving as the second electrode of the semiconductor layer ACT of the transistor and the anode connection electrode CE-an is electrically connected through an opening located at the gate insulating film 141, the interlayer insulating film 161, and the planarization film 181, and the anode connection electrode CE-an transfers a current to the anode Anode through the third opening OPcon. The current transferred to the anode Anode passes through the light emitting layer EML, and is transferred to the cathode Cathode. The light emitting layer EML emits light due to a current flowing through the light emitting layer EML so that the light emitting element shows luminance. According to some embodiments, the anode connection electrode CE-an may not be included between the semiconductor layer ACT of the transistor and the anode Anode or an additional connection electrode may be further included between the semiconductor layer ACT of the transistor and the anode Anode.

Because FIG. 7 has the cross-sectional structure according to some embodiments, various modified structures may be possible.

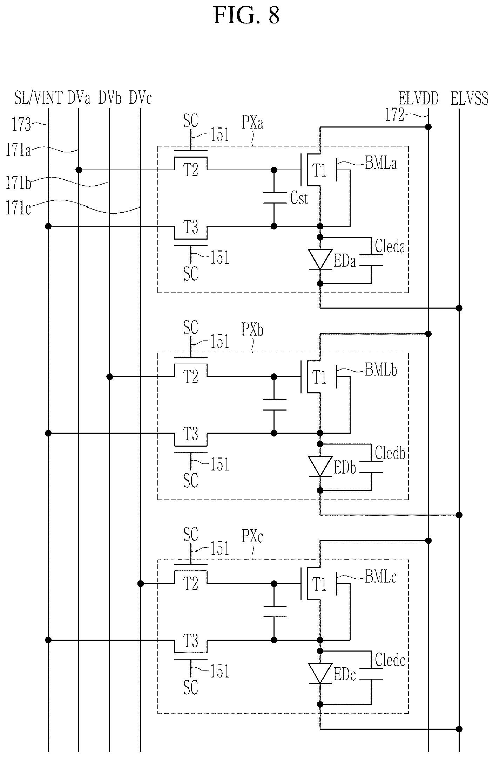

Hereinafter, embodiments having a circuit structure different from that of FIG. 1 will be described with respect to FIG. 8.

FIG. 8 is a circuit diagram of a pixel of a light emitting display device according to some embodiments.

Unlike FIG. 1, scan signal lines connected to the input transistor T2 and the initialization transistor T3 are the same signal line in FIG. 8. That is, the embodiments illustrated and described with respect to FIG. 8 do not include the second scan signal line 151-1 that transfers the second scan signal SS, and the first scan signal line 151 that transfers the first scan signal SC is connected to the gate electrode of the input transistor T2 and the gate electrode of the initialization transistor T3.

In addition, in the embodiments illustrated and described with respect to FIG. 8, the driving transistor T1 may further include a lower shielding layer BMLa, BMLb, or BMLc overlapping the driving transistor T1. The lower shielding layer BMLa, BMLb, or BMLc are formed of a conductive material, and is electrically connected to one electrode of the driving transistor T1. Specifically, in FIG. 8, the lower shielding layer BMLa, BMLb, or BMLc is connected to the second electrode of the driving transistor T1, the anode of the light emitting element EDa, EDb, or EDc, the other end of the storage capacitor Cst, and the first electrode of the initialization transistor T3.

Other structures of FIG. 8 may be the same as the circuit structure of FIG. 1, and thus a description thereof is omitted.

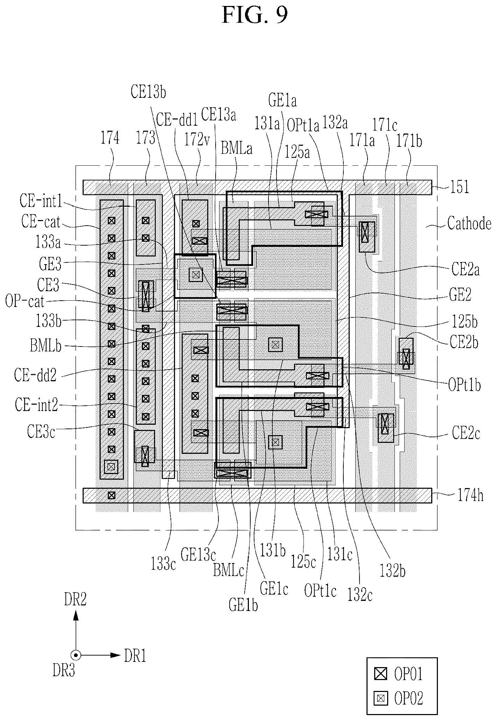

A pixel having the circuit structure shown in FIG. 8 may have a planar structure and a cross-sectional structure shown in FIGS. 9 to 14.

First, a detailed planar structure of a pixel driving portion (or a pixel circuit portion) of the pixel PXa, PXb, or PXc having the circuit structure shown in FIG. 8 will be described through FIGS. 9 to 13.

FIG. 9 to FIG. 13 are plan views illustrating a display area of the light emitting display device according to a manufacturing sequence according to some embodiments.

First, a planar structure up to the cathode Cathode located at the driving element layer and the light emitting element layer will be described through FIG. 9. The planarization film 181 is formed between the driving element layer and the cathode Cathode.

Further details of a planar structure of a lower shielding conductive layer including the lower shielding layer, according to some embodiments, is as follows.

The lower shielding conductive layer including the lower shielding layer BMLa, BMLb, or BMLc, a lower storage electrode 125a, 125b, or 125c, the data line 171a, 171b, or 171c, a first driving voltage line 172v, the initialization voltage line 173, and the driving low voltage line 174 is formed above or on the substrate 110.

The lower shielding layer BMLa, BMLb, or BMLc may be formed in an island shape, and may overlap the semiconductor layer including the channel of each driving transistor T1 in a subsequent process.

The lower storage electrode 125a, 125b, or 125c is adjacent to the lower shielding layer BMLa, BMLb, or BMLc, and is formed in an island shape. The lower storage electrode 125a, 125b, or 125c serves as one electrode of the storage capacitor Cst.

The data line 171a, 171b, or 171c extends in the second direction DR2, and is respectively connected to the pixel PXa, PXb, or PXc so that each data voltage DVa, DVb, or DVc is transferred to each pixel PXa, PXb, or PXc.

The first driving voltage line 172v, the initialization voltage line 173, and the driving low voltage line 174 respectively extend in the second direction DR2, and respectively transfer the driving voltage ELVDD, the initialization voltage VINT, and the driving low voltage ELVSS.

The lower shielding conductive layer is covered by the buffer layer 111.

The semiconductor layer ACT formed of a silicon semiconductor (e.g., a polycrystalline semiconductor) or an oxide semiconductor is located on the buffer layer 111. The semiconductor layer includes a semiconductor (hereinafter also referred to as a first semiconductor) 131a, 131b, or 131c of the driving transistor T1, a semiconductor (hereinafter also referred to as a second semiconductor) 132a, 132b, or 132c of the input transistor T2, and a semiconductor (hereinafter also referred to as a third semiconductor) 133a, 133b, or 133c of the initialization transistor T3. The first semiconductor 131a, 131b, or 131c includes a portion (hereinafter also referred to as an upper storage electrode) overlapping the lower storage electrode 125a, 125b, or 125c.

The semiconductor layer is covered with the gate insulating film 141.

An opening OP01 is formed at the gate insulating film 141 to expose portions of the lower shielding conductive layer and the semiconductor layer located below the gate insulating film 141.

One end of the first semiconductor 131a, 131b, or 131c may be connected to the first driving voltage line 172v through the opening OP01, and the other end of the first semiconductor 131a, 131b, or 131c may be connected to the lower shielding layer BMLa, BMLb, or BMLc through the opening OP01.

One end of the second semiconductor 132a, 132b, or 132c may be connected to the data line 171a, 171b, or 171c through the opening OP01, and the other end of the second semiconductor 132a, 132b, or 132c may be connected to the lower storage electrode 125a, 125b, or 125c through the opening OP01.

One end of the third semiconductors 133a, 133b, or 133c may be connected to the initialization voltage line 173 through the opening OP01, and the other end of the third semiconductors 133a, 133b, or 133c may be connected to the lower shielding layer BMLa, BMLb, or BMLc through the opening OP01.

A plurality of openings OP01 overlapping the first driving voltage line 172v, the initialization voltage line 173, and the driving low voltage line 174 may be further included.

The first gate conductive layer is formed on the gate insulating film 141.

The first gate conductive layer includes the first scan signal line 151, an additional driving low voltage line 174h, a first gate electrode GE1a, GE1b, or GE1c of the driving transistor T1, a connecting electrode CE2a, CE2b, CE2c, CE13a, CE13b, CE13c, CE3, CE3c, CE-dd1, or CE-dd2, and an auxiliary electrode CE-int1, CE-int2, or CE-cat.

The first scan signal line 151 may extend in the first direction DR1, and may further include a second gate electrode GE2 and a third gate electrode GE3 protruding in the second direction DR2. The second gate electrode GE2 extends in the second direction DR2 to overlap a portion of each of the second semiconductors 132a, 132b, and 132c, and the third gate electrode GE3 also extends in the second direction DR2 to overlap a portion of each of the third semiconductors 133a, 133b, and 133c overlap with

The additional driving low voltage line 174h extends in the first direction DR1, and is electrically connected to the driving low voltage line 174 through the opening OP01 to transfer the driving low voltage ELVSS.

One end of the first gate electrode GE1a, GE1b, or GE1c of the driving transistor T1 is connected to one end of the second semiconductor 132a, 132b, or 132c and the lower storage electrode 125a, 125b, or 125c through the opening OP01. The other end of the first gate electrode GE1a, GE1b, or GE1c of the driving transistor T1 is extended in the first direction DR1 and then bent and extended in the second direction DR2, and the portion extended in the second direction DR2 overlaps portions of the lower shielding layer BMLa, BMLb, or BMLc and the first semiconductor 131a, 131b, or 131c.

The connecting electrode CE2a, CE2b, or CE2c connects one end of the second semiconductor 132a, 132b, or 132c to the data line 171a, 171b, or 171c through the opening OP01.

The connecting electrode CE13a, CE13b, or CE13c connects one end of the first semiconductor 131a, 131b, or 131c and one end of the third semiconductor 133a, 133b, or 133c to the lower shielding layer BMLa, BMLb, or BMLc through the opening OP01.

The connecting electrode CE3 or CE3c connects one end of the third semiconductor 133a, 133b, or 133c to the initialization voltage line 173 through the opening OP01.

The connecting electrode CE-dd1 or CE-dd2 connects one end of the first semiconductor 131a, 131b, or 131c to the first driving voltage line 172v through the opening OP01.

The auxiliary electrode CE-int1 or CE-int2 are connected to the initialization voltage line 173 through the plurality of openings OP01, and the auxiliary electrode CE-cat is connected to the driving low voltage line 174 through the plurality of openings OP01.

The first gate conductive layer is covered by the interlayer insulating film 161 and the planarization film 181.

An opening OP02 is formed at the interlayer insulating film 161 and the planarization film 181.

The opening OP02 exposes a portion of the third semiconductor 133a, 133b, or 133c, and the opening OP02 exposes a portion of the auxiliary electrode CE-cat.

Referring to FIGS. 9 to 12, the cathode Cathode including an opening OPt1a, OPt1b, OPt1c, or OP-cat is formed on the planarization film 181. The cathode Cathode is electrically connected to the auxiliary electrode CE-cat and the driving low voltage line 174 by the opening OP02 located at the interlayer insulating film 161 and the planarization film 181. Here, the opening OP-cat is also referred to as a first opening or a contact opening, and opening OPt1a is also referred to as a second opening or a driving gate electrode overlapping opening. On the other hand, the opening OPt1b or OPt1c is an opening that includes both the first opening and the second opening, and may be divided into regions corresponding to the two openings.

The opening OPt1a, OPt1b, or OPt1c overlaps the first gate electrode GE1a, GE1b, or GE1c of the driving transistor T1. The opening OPt1a, OPt1b, or OPt1c prevents the cathode Cathode and the first gate electrode GE1a, GE1b, or GE1c of the driving transistor T1 from overlapping on a plane, and the first gate electrode GE1a, GE1b, or GE1c does not generate parasitic capacitance with the cathode.

The opening OPt1b or OPt1c is located at the interlayer insulating film 161 and the planarization film 181, and overlaps the opening (hereinafter also referred to as a pixel driving portion opening (or a pixel circuit portion opening)) OP02 exposing a portion of the first semiconductor 131b or 131c. On the other hand, the opening OPt1a does not overlap the pixel driving portion opening OP02, and the pixel driving portion opening OP02 overlaps the opening OP-cat located at the cathode Cathode. The pixel driving portion opening OP02 overlapping the opening OP-cat may be located at the interlayer insulating film 161 and the planarization film 181, and may expose a portion of the third semiconductor 133a. The pixel driving portion opening OP02 overlaps the anode Anodea, Anodeb, or Anodec located on the light emitting layer so that the pixel driving portion PCa, PCb, or PCc located below the pixel driving portion opening OP02 transfers a current to the anode Anodea, Anodeb, or Anodec.

On the other hand, according to some embodiments, the anode connection electrode CE-an of FIG. 7 formed of the same material as the cathode Cathode may be further included. The anode connection electrode CE-an may be located within the opening OPt1b or OPt1c and the pixel driving portion opening OP02 formed at the cathode Cathode.

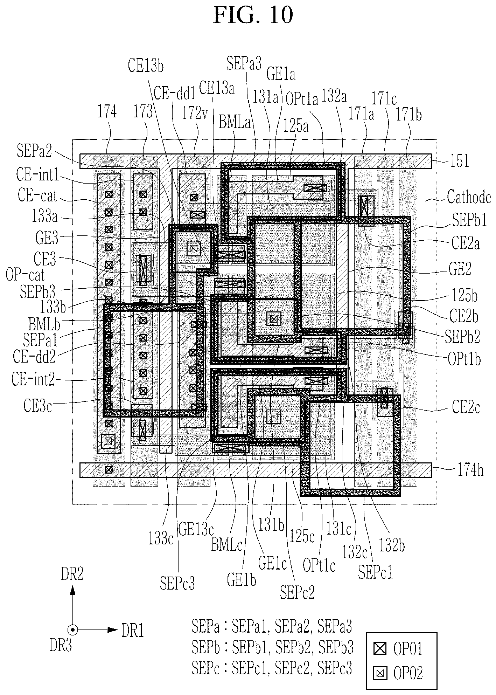

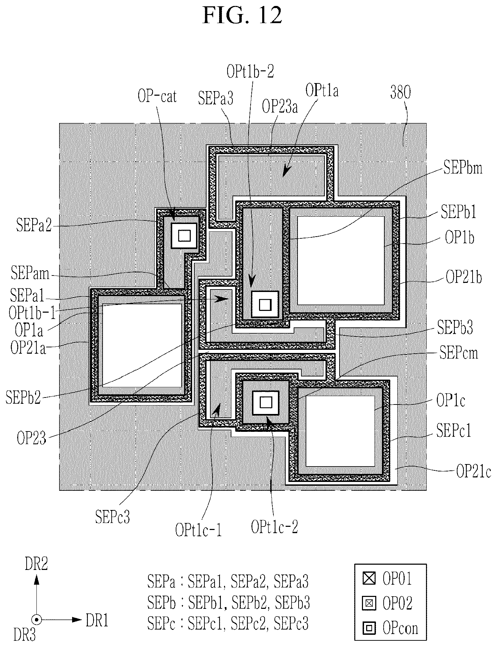

Referring to FIGS. 10 and 12, the separator SEP is formed on the cathode Cathode.

The separator SEP may be divided into the separators SEPa, SEPb, and SEPc, and each separator SEPa, SEPb, or SEPc may include the outer portion SEPa1, SEPb1, SEPc1, SEPa2, SEPb2, or SEPc2, the inner portion SEPam, SEPbm, or SEPcm, and an additional portion SEPa3, SEPb3, or SEPc3. The separator SEPa, SEPb, or SEPc may have a structure having a reverse-tapered sidewall. Each of the separators SEPa, SEPb, and SEPc may form a closed curved line on a plane, and the anode may be separated based on the separator SEPa, SEPb, or SEPc. Each of the separators SEPa, SEPb, and SEPc may be separated and located at a distance (e.g., a set or predetermined distance) from each other, but according to some embodiments, at least portions of the separators SEPa, SEPb, and SEPc may be formed in a structure that is shared with each other. Each of the separators SEPa, SEPb, and SEPc may further include the inner portion SEPam, SEPbm, or SEPcm crossing to separate a region divided by the outer portion SEPa1, SEPb1, SEPc1, SEPa2, SEPb2, or SEPc2 into two portions. The inner portion SEPam, SEPbm, or SEPcm divides the region divided by the outer portion SEPa1, SEPb1, SEPc1, SEPa2, SEPb2, or SEPc2 into a first region (hereinafter also referred to as a light emitting region) in which the light emitting layer EMLa, EMLb, or EMLc are located to correspond to the light emitting region and a second region (hereinafter also referred to as a contact region) corresponding to the opening OPcon of the pixel defining layer 380 for connecting an upper anode Anodea, Anodeb, or Anodec to the pixel driving portion PCa, PCb, or PCc. Here, the first region may correspond to the opening OP1a, OP1b, or OP1c of the pixel defining layer 380. Here, the outer portion SEPa1, SEPb1, SEPc1, SEPa2, SEPb2, or SEPc2 may be divided into the first outer portion SEPa1, SEPb1, or SEPc1 of the first region and the second outer portion SEPa2, SEPb2, or SEPc2 of the second region.

In addition, an additional region (hereinafter also referred to as a third region) divided by the additional portion SEPa3, SEPb3, or SEPc3 may be located outside the region divided by the outer portion SEPa1, SEPb1, SEPc1, SEPa2, SEPb2, or SEPc2, and the additional region may correspond to the opening OPt1a, OPt1b, OPt1c, or OP-cat located at the cathode Cathode. More specifically, the additional region divided by the additional portion SEPa3, SEPb3, or SEPc3 may overlap a portion of the opening OPt1a, OPt1b, or OPt1c overlapping the first gate electrode GE1a, GE1b, or GE1c of the driving transistor T1. As a result, parasitic capacitance may be reduced by preventing the first gate electrode GE1a, GE1b, or GE1c of the driving transistor T1 from overlapping the anode Anodea, Anodeb, or Anodec on a plane.

Referring to FIG. 12, an edge of the opening OPt1b or OPt1c located at the cathode Cathode may overlap the separator SEPb1, SEPb2, SEPb3, SEPc1, SEPc2, or SEPc3 on a plane, and the separator SEPb1, SEPb2, SEPc1, or SEPc2 may be divided into an opening OPt1b-1 or OPt1c-1 corresponding to the additional region on the plane and an opening OPt1b-2 or OPt1c-2 corresponding to the second region. An edge of the opening OPt1a located at the cathode Cathode may have a structure overlapping the separator SEPb1, SEPb2, or SEPa3 on a plane.

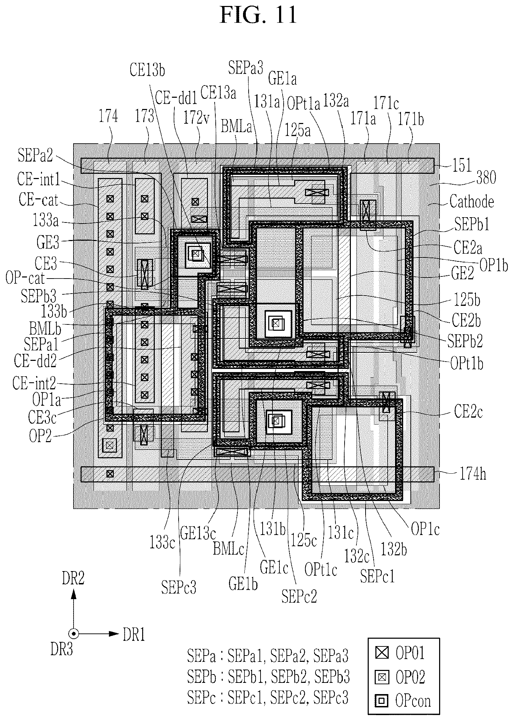

Referring to FIGS. 11 and 12, the pixel defining layer 380 including the opening OP1a, OP1b, OP1c, OP2, or OPcon is formed at the cathode Cathode and the separator SEP.

Specifically, the pixel defining layer 380 includes the first opening (hereinafter also referred to as a light-emitting region opening) OP1a, OP1b, or OP1c, the second opening (also referred to as an opening for exposing the separator) OP2, and the third opening (also referred to as an opening for connecting the anode) OPcon.

The first opening OP1a, OP1b, or OP1c is an opening corresponding to the light emitting layer EMLa, EMLb, or EMLc, and is an opening corresponding to the light emitting element or the light emitting region. The first openings OP1a, OP1b, and OP1c may have a different size for each color, and may have a planar shape of a rectangle, a polygon, a circle, or an oval, or a planar shape with chamfered corners.

The second opening OP2 form a closed curved line and overlap at least one portions of the separators SEPa, SEPb, and SEPc to expose at least one portions of the separators SEPa, SEPb, and SEPc, and in the embodiments illustrated and described with respect to FIGS. 11 and 12, the second opening OP2 is integrally connected to an entire separator SEPa, SEPb, or SEPc. At least one sides of the outer portion SEPa1, SEPb1, SEPc1, SEPa2, SEPb2, or SEPc2 and the additional portion SEPa3, SEPb3, or SEPc3 of the separator SEPa, SEPb, or SEPc having a reverse taper structure may be exposed by the second opening OP2, and a layer located at an upper portion of the separator SEPa, SEPb, or SEPc may be separated by the exposed sides of the separator SEPa, SEPb, or SEPc. In the embodiments illustrated and described with respect to FIGS. 11 and 12, only one side of the outer portion SEPa1, SEPb1, SEPc1, SEPa2, SEPb2, or SEPc2 may be exposed by the second opening OP2, and both sides of the additional portion SEPa3, SEPb3, or SEPc3 may be exposed by the second opening OP2. On the other hand, the second opening OP2 does not overlap the inner portion SEPam, SEPbm, or SEPcm of the separator SEPa, SEPb, or SEPc. That is, the inner portion SEPam, SEPbm, or SEPcm of the separator SEPa, SEPb, or SEPc is covered with the pixel defining layer 380.

The second opening OP2 overlaps an outer side surface of the outer portion SEPa1, SEPb1, SEPc1, SEPa2, SEPb2, or SEPc2 so that the outer side surface of the outer portion SEPa1, SEPb1, SEPc1, SEPa2, SEPb2, or SEPc2 is exposed by the second opening OP2a, OP2b, or OP2c.

According to an overlapping structure of the second opening OP2 and the separator SEPa, SEPb, or SEPc of the pixel defining layer 380, the anodes Anodea, Anodeb, and Anodec located above or on the separators SEPa, SEPb, and SEPc and the pixel defining layer 380 are separated based on outer side surfaces of the outer portions SEPa1, SEPb1, SEPc1, SEPa2, SEPb2, and SEPc2. In addition, the anodes Anodea, Anodeb, and Anodec located above or on the separators SEPa, SEPb, and SEPc are not separated by the inner portions SEPam, SEPbm, and SEPcm of the separators SEPa, SEPb, and SEPc covered by the pixel defining layer 380 and inner side surfaces of the outer portions SEPa1, SEPb1, SEPc1, SEPa2, SEPb2, and SEPc2 of the separators SEPa, SEPb, and SEPc. Since the inner portions SEPam, SEPbm, and SEPcm of the separators SEPa, SEPb, and SEPc are covered with the pixel defining layer 380, the anodes Anodea, Anodeb, and Anodec located above or on the separators SEPa, SEPb, and SEPc are integrally formed without being separated into the first and second regions. On the other hand, the anodes located above or on the additional portion SEPa3, SEPb3, or SEPc3 may be separated by the additional portion SEPa3, SEPb3, or SEPc3 having both surfaces exposed by the second opening OP2.

On the other hand, the third opening OPcon may be an opening for connecting the anode Anodea, Anodeb, or Anodec and the pixel driving portion PCa, PCb, or PCc, and may include an opening located at the pixel defining layer 380 and an insulating film located at a lower portion of the pixel defining layer 380. Referring to FIG. 9, the separator SEPa, SEPb, or SEPc may be connected to the anode Anodea, Anodeb, or Anodec through the opening OPcon of the pixel defining layer 380 within the opening OP-cat and the opening OPt1b or OPt1c located at the cathode Cathode and within the second region.

According to some embodiments, the fourth opening OP4 of the embodiments illustrated and described with respect to FIG. 3 connecting the auxiliary electrode Cathode-add and the cathode Cathode may be further added so that the fourth opening OP4 allows the driving low voltage ELVSS applied to the cathode Cathode to be transferred to the auxiliary electrode Cathode-add formed of the same material as the anode Anodea, Anodeb, or Anodec.

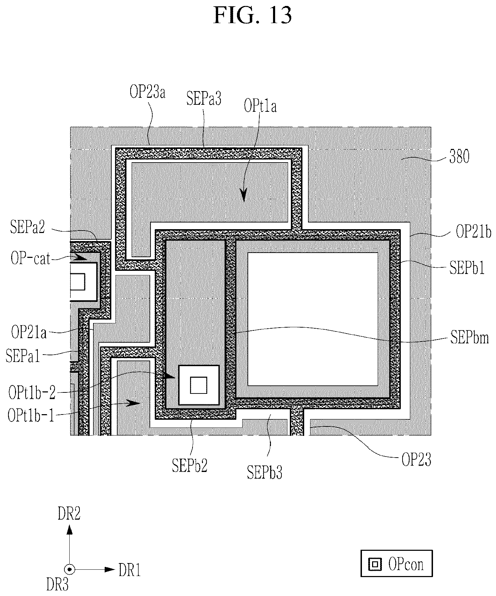

Referring to FIGS. 12 and 13, an anode conductive layer (also referred to as a second conductive layer) including the anode Anodea, Anodeb, or Anodec is formed on the separator SEP and the pixel defining layer 380.

Unlike FIGS. 9 to 11, FIG. 12 does not show an overall structure, and only shows the cathode Cathode, the separator SEPa, SEPb, or SEPc, the pixel defining layer 380, and the anode conductive layer. In FIG. 12, a structure of each layer preceding structures of the cathode Cathode, the separator SEPa, SEPb, or SEPc, the pixel defining layer 380, and the anode conductive layer is omitted in order to more clearly identify the structures of the cathode Cathode, the separator SEPa, SEPb, or SEPc, the pixel defining layer 380, and the anode conductive layer. On the other hand, FIG. 13 is an enlarged view of a portion of FIG. 12.

When a material for the anode conductive layer is stacked on the structure of FIG. 11, the anodes Anodea, Anodeb, and Anodec automatically separated by a sidewall of a reverse taper structure of the separator SEPa, SEPb, or SEPc exposed by the opening OP2 of the pixel defining layer 380, may be formed.

Specifically, in FIGS. 12 and 13, each anode Anodea, Anodeb, or Anodec is formed by the outer portion SEPa1, SEPb1, SEPc1, SEPa2, SEPb2, or SEPc2 overlapping the opening OP2 of the pixel defining layer 380. Each anode Anodea, Anodeb, or Anodec is integrally formed without being separated into the first region and the second region divided by the separator SEPa, SEPb, or SEPc, and each anode Anodea, Anodeb, or Anodec has a structure overlapping the inner portion SEPam, SEPbm, or SEPcm of the separator SEPa, SEPb, or SEPc. The inner portion SEPam, SEPbm, or SEPcm is covered by the pixel defining layer 380 so that the anodes Anodea, Anodeb, and Anodec located above or on the inner portions SEPam, SEPbm, and SEPcm are not separated.

The edge of the anode Anodea, Anodeb, or Anodec may coincide with the outer portion SEPa1, SEPb1, SEPc1, SEPa2, SEPb2, or SEPc2 exposed by the second opening OP2 of the pixel defining layer 380 on a plane.

On the other hand, each anode Anodea, Anodeb, or Anodec located at the second region is electrically connected to the pixel driving portion PCa, PCb, or PCc located below each anode Anodea, Anodeb, or Anodec through the third opening OPcon located at the pixel defining layer 380 and the opening OP-cat and the opening OPt1b or OPt1c located at the cathode Cathode. As a result, each anode Anodea, Anodeb, or Anodec may receive a current from the pixel driving portion PCa, PCb, or PCc.

On the other hand, the anode conductive layer may further include an additional electrode AFE and the auxiliary electrode Cathode-add.

The additional electrode AFE may be separated by the additional portion SEPa3, SEPb3, or SEPc3 and the outer portion SEPb1, SEPc1, SEPb2, or SEPc2 of the separator SEPa, SEPb, or SEPc exposed by the opening OP2 of the pixel defining layer 380. The additional electrode AFE may be automatically separated by a sidewall of a reverse taper structure of the additional portion SEPa3, SEPb3, or SEPc3 or the like. The additional electrode AFE may not receiving a separate voltage to be floating, and according to some embodiments, the additional electrode AFE may receive a constant voltage.

The additional electrode AFE may correspond to the additional region divided by the additional portion SEPa3, SEPb3, or SEPc3 and the outer portion SEPb1, SEPc1, SEPb2, or SEPc2, and the additional electrode AFE may overlap a portion of the opening OPt1a, OPt1b, OPt1c, or OP-cat located at the cathode Cathode overlapping the first gate electrode GE1a, GE1b, or GE1c of the driving transistor T1. The additional region may reduce parasitic capacitance by preventing the first gate electrode GE1a, GE1b, or GE1c of the driving transistor T1 from overlapping the cathode Cathode and the anode Anodea, Anodeb, or Anodec on a plane. The additional electrode AFE overlaps the first gate electrode GE1a, GE1b, or GE1c of the driving transistor T1 on a plane. However, the pixel defining layer 380 is located between the additional electrode AFE and the first gate electrode GE1a, GE1b, or GE1c of the driving transistor T1 so that the additional electrode AFE is relatively far from the first gate electrode of the driving transistor T1 and unlike the anode Anodea, Anodeb, or Anodec, the additional electrode AFE does not receive a current. Thus, the additional electrode AFE does not affect the first gate electrode GE1a, GE1b, or GE1c of the driving transistor T1.

The additional electrode AFE may be formed of the same material as the anode Anodea, Anodeb, or Anodec, some of edges of the additional electrode AFE may coincide with the additional portion SEPa3, SEPb3, or SEPc3 exposed by the second opening OP2 of the pixel defining layer 380 on a plane, and the remaining edge of the additional electrode AFE may coincide with some of the outer portions SEPb1, SEPc1, SEPb2, and SEPc2 exposed by the second opening OP2 of the pixel defining layer 380 on a plane.

The auxiliary electrode Cathode-add may be a portion other than the anode Anodea, Anodeb, or Anodec and the additional electrode AFE separated by the opening OP2 of the pixel defining layer 380 and the separator SEPa, SEPb, or SEPc, and may have an integrally connected structure. According to some embodiments, the auxiliary electrode Cathode-add may not receiving a separate voltage to be floating, and according to some embodiments, the additional electrode AFE may receive a constant voltage. When the pixel defining layer 380 has the fourth opening OP4 of the embodiments illustrated and described with respect to FIG. 3, the driving low voltage ELVSS applied to the cathode Cathode may be applied to the auxiliary electrode cathode-add.

Referring to FIGS. 12 and 13, two additional portions SEPa3 and SEPb3 are connected to the outer portions SEPb1 and SEPb2 of the second separator SEPb of the separators SEPa, SEPb, and SEPc, the outer portions SEPa1 and SEPb3 of the first separator SEPa2 is not connected to the additional portion, and one additional portion SEPc3 is connected to the outer portions SEPc1 and SEPc2 of the third separator SEPc. According to some embodiments, the outer portion of the separator may not be connected to the additional portion or may be connected to at least one additional portion.

In addition, the first separator SEPa, the second separator SEPb, and the third separator SEPc may be separated, and the separated portion may overlap the second opening OP2 of the pixel defining layer 380 so that the second conductive layer is separated. As a result, adjacent anodes Anodea, Anodeb, and Anodec may be electrically separated.

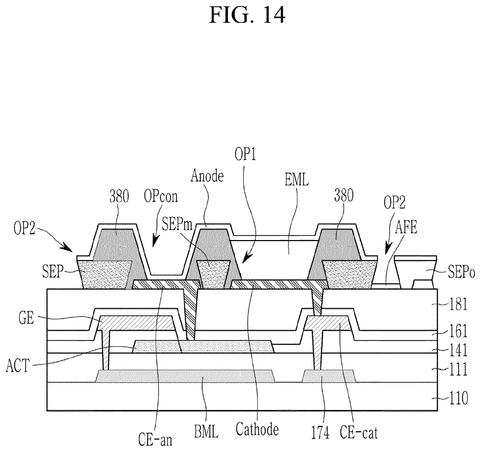

Hereinafter, a cross-sectional structure of the light emitting display device will be described through FIG. 14.

FIG. 14 is a cross-sectional view of the light emitting display device according to the embodiments of FIGS. 9 to 13.

In FIG. 9, a separate anode connection electrode CE-an is not formed within the openings OPt1b and OPt1c of the cathode Cathode and the opening OP02 of the pixel driving portion, but in the embodiments illustrated and described with respect to FIG. 14, embodiments in which the anode connection electrode CE-an is formed will be mainly described. However, according to some embodiments, as shown in FIG. 9, the anode may be electrically connected to the transistor of the pixel driving portion PCa, PCb, or PCc without the anode connection electrode CE-an.

When the structure of FIG. 14 is compared with the structure of FIG. 7, there is no difference in structures of the planarization film 181 and the driving element layer located below the planarization film 181, and thus a description thereof is omitted.

A description of a structure of the light emitting element layer located above or on the driving element layer according to the embodiments illustrated and described with respect to FIG. 14 is as follows.

A first electrode layer including the cathode Cathode and the anode connection electrode CE-an is formed on the planarization film 181. The anode connection electrode CE-an is located within the opening OP-cat of the cathode Cathode to be electrically separated from the cathode Cathode. A portion of the cathode Cathode may overlap the light emitting layer EML located within the first opening OP1 of the pixel defining layer 380 to overlap the light emitting region and constitute the light emitting element. The anode connection electrode CE-an is electrically connected to the anode Anode in a subsequent process.

The separator SEP may be located on the planarization film 181, and at least a portion of the separator SEP may overlap a portion of the first electrode layer.

The separator SEP may have a sidewall with a reverse-tapered structure, and may be divided into a first outer portion (SEP1) of the first region located outside the cathode Cathode, a second outer portion (SEP2) of the second region located outside the anode connection electrode CE-an, an inner portion SEPm located between the cathode Cathode and the anode connection electrode CE-an, and an additional portion (SEP3). The anode Anode is separated by the first outer portion (SEP1) of the first region and the second outer portion (SEP2) of the second region, and the inner portion SEPm overlaps the anode Anode and does not separate the anode Anode. The first region may be a region between the first outer portion (SEP1) and the inner portion SEPm, and the second region may be a region between the second outer portion (SEP2) and the inner portion SEPm. The additional region may be located between the additional portion (SEP3) and the outer portion (SEP1 or SEP2).

The pixel defining layer 380 including the openings OP1, OP2, and OPcon is formed on the planarization film 181, the first electrode layer, and the separator SEP.

The first opening OP1 of the pixel defining layer 380 may correspond to the light emitting element and/or the light emitting region, and may correspond to the first region divided by the separator SEP. The pixel defining layer 380 dividing the first opening OP1 of the pixel defining layer 380 may overlap the first outer portion (SEP1) and the inner portion SEPm of the separator SEP.

The first opening OP1 of the pixel defining layer 380 may expose a portion of the cathode Cathode, and the light emitting layer EML may be located at the first opening OP1 of the pixel defining layer 380. Here, the light emitting layer EML may be formed by the inkjet method.

The second opening OP2 of the pixel defining layer 380 may be an opening formed along the first outer portion (SEP1), the second outer portion (SEP2), and the additional portion (SEP3) of the separator SEP, and may expose tapered side surfaces of the first outer portion (SEP1) and the second outer portion (SEP2) so tht the anode Anode formed subsequently is separated based on the separator SEP. On the other hand, the second conductive layer formed subsequently may be separated based on the additional portion (SEP3). Here, the pixel defining layer 380 dividing the second opening OP2 of the pixel defining layer 380 may overlap the first outer portion (SEP1) and the second outer portion (SEP2) of the separator SEP, and may expose an outer sidewall of the separator SEP. Both sidewalls of the additional portion (SEP3) may be exposed by the second opening OP2 of the pixel defining layer 380.

The third opening OPcon of the pixel defining layer 380 may be a portion where the anode connection electrode CE-an and the anode Anode are connected, and may correspond to the second region divided by the separator SEP. The pixel defining layer 380 dividing the third opening OPcon of the pixel defining layer 380 may overlap the second outer portion (SEP2) and the inner portion SEPm of the separator SEP. The third opening OPcon of the pixel defining layer 380 may be electrically connected to the anode Anode formed subsequently by exposing a portion of the anode connection electrode CE-an.

The light emitting layer EML, the anode Anode, the additional electrode AFE, and the auxiliary electrode Cathode-add may be located above or on the planarization film 181, an exposed cathode Cathode, an exposed anode connection electrode CE-an, an exposed separator SEP, and the pixel defining layer 380.

The light emitting layer EML may be located within the first opening OP1 of the pixel defining layer 380, and a second functional layer is located between the cathode Cathode and the light emitting layer EML. In addition, a first functional layer may be located above or on the light emitting layer EML. Here, the first functional layer may include a hole injection layer and/or a hole transport layer, and the second functional layer may include an electron transport layer and/or an electron injection layer. According to some embodiments, the first functional layer and the second functional layer may be located above or on the pixel defining layer 380, and both sides of the first functional layer and the second functional layer may be separated from each other based on the exposed separator SEP.

A second electrode layer including the anode Anode is formed on the light emitting layer EML, the pixel defining layer 380, and the openings OP1, OP2, and OPcon.

The anode Anode is separated by the exposed separator SEP, the anode Anode is also formed at the pixel defining layer 380 and the openings OP1 and OPcon, and a portion of the anode Anode is also located on the light emitting layer EML.

On the other hand, the second electrode layer may further include the additional electrode AFE located at an upper surface of the additional portion (SEP3) not covered with the pixel defining layer 380. In addition, the second electrode layer may further include the auxiliary electrode Cathode-add located outside the anode Anode and the additional electrode AFE. The auxiliary electrode Cathode-add may be connected to the cathode Cathode to receive the second voltage ELVSS.

If the second electrode layer including the anode Anode, the additional electrode AFE, and the auxiliary electrode Cathode-add is stacked without a separate mask, an automatically separated structure is formed by a portion of the separator SEP not covered by the pixel defining layer 380. That is, the second electrode layer formed at an upper portion of the separator SEP is separated into the anode Anode and the electrode auxiliary Cathode-add without a separate etching process by a reverse-tapered sidewall of the exposed separator SEP.

Referring to FIG. 14, a portion serving as the second electrode of the semiconductor layer ACT of the transistor and the anode connection electrode CE-an is electrically connected through an opening located at the gate insulating film 141, the interlayer insulating film 161, and the planarization film 181, and the anode connection electrode CE-an transfers a current to the anode Anode through the third opening OPcon. The current transferred to the anode Anode passes through the light emitting layer EML, and is transferred to the cathode Cathode. The light emitting layer EML emits light due to a current flowing through the light emitting layer EML so that the light emitting element shows luminance. According to some embodiments, the anode connection electrode CE-an may not be included between the semiconductor layer ACT of the transistor and the anode Anode or an additional connection electrode may be further included between the semiconductor layer ACT of the transistor and the anode Anode.

Because FIG. 14 has the cross-sectional structure according to some embodiments, various modified structures may be possible.

As discussed, embodiments may provide a light emitting display device, comprising: a substrate; a driving element layer on the substrate and including a transistor and a planarization film covering the transistor; a second electrode on the planarization film and including a contact opening; a separator on the planarization film and has a reverse-tapered sidewall; a pixel defining layer including a first opening exposing a portion of the second electrode, a second opening exposing a portion of the separator, and a third opening corresponding to the contact opening of the second electrode; and a first electrode on the pixel defining layer, wherein the first electrode is electrically connected to the transistor of the driving element layer through the contact opening of the second electrode and the third opening of the pixel defining layer.

The third opening may overlap the contact opening in a plan view.

The separator may include an outer portion and an inner portion, and the second opening of the pixel defining layer may expose at least a portion of the outer portion of the separator. The second electrode may be a cathode, and the first electrode may be an anode.

The separator may be divided into the separators, and each of the separator portions may include the outer portion, the inner portion, and an additional portion. The separator portions may each have a structure having a reverse-tapered sidewall. Each of the separator portions may form a closed curved line on a plane, and the first electrode may be separated based on the separator portion. Each of the separator portions may be separated and located at a distance (e.g., a set or predetermined distance) from each other.

An edge of the first electrode may coincides with the outer portion exposed by the second opening when considered in a plan view.

In some embodiments, all side surfaces of the inner portion are covered by the pixel defining layer. The inner portion may overlap the first electrode when considered in a plan view.

The separator may further include an additional portion, and the second opening of the pixel defining layer may expose at least a portion of the additional portion.

The light emitting display may further comprise an additional electrode formed of a same material as the first electrode, wherein some of edges of the additional electrode coincide with the additional portion exposed by the second opening when considered in a plan view. Remaining ones of the edges of the additional electrode may coincide with a portion of the outer portion when considered in a plan view. A central portion of the additional electrode excluding the edges may overlap the pixel defining layer when considered in a plan view.

Embodiments may provide a light emitting display device, comprising: a substrate; a driving element layer on the substrate and including a driving transistor and a planarization film covering the driving transistor; a second electrode on the planarization film and including a driving gate electrode overlapping opening overlapping a gate electrode of the driving transistor when considered in a plan view; a separator on the planarization film, having a reverse-tapered sidewall, and including an outer portion, an inner portion, and an additional portion; a pixel defining layer including a first opening exposing a portion of the second electrode and a second opening exposing at least portions of the outer portion and the additional portion of the separator; and a first electrode and an additional electrode at an upper potion of the pixel defining layer, wherein an edge of the first electrode coincides with the outer portion exposed by the second opening when considered in a plan view.

In the above, it has been described that the cathode is located at a lower portion and the anode is located at an upper portion. However, according to some embodiments, the cathode may be located at the upper portion and the anode may be positioned at the lower portion, and in this case, the cathode may be connected to a lower transistor through an opening on the pixel defining layer. Therefore, an expression such as "a first electrode and a second electrode" may be used instead of an expression such as "the anode and the cathode".

While aspects of some embodiments of the present disclosure have been described in connection with what is presently considered to be practical embodiments, it is to be understood that the disclosure is not limited to the disclosed embodiments, but, on the contrary, is intended to cover various modifications and equivalent arrangements included within the scope of the appended claims, and their equivalents.

### Description of Some of the Reference Symbols

SEP, SEPa, SEPb, SEPc: separator
SEP1, SEP2, SEPa1, SEPa2, SEPb1, SEPb2, SEPc1, SEPc2: outer portion
SEP3, SEPa3, SEPb3, SEPc3: additional portion
SEPm, SEPam, SEPbm, SEPcm: inner portion
380: pixel defining layer
Cathode: cathode
OP-cat, OP01, OP02, OP1, OP2, OPcon, OP1a, OP1b, OP1c, OP2a, OP2b, OP2c,
OP4, OPt1a, OPt1b, OPt1c, OPt1b-1, OPt1c-1, OPt1b-2, OPt1c-2: opening
Anode, Anodea, Anodeb, Anodec: anode
Cathode-add: auxiliary electrode
AFE: additional electrode
CE-an: anode connection electrode
CE-int1, CE-int2, CE-cat: auxiliary electrode
CM, CE2a, CE2b, CE2c, CE13a, CE13b, CE13c, CE3, CE3c, CE-dd1, CE-dd2: connecting electrode
PCa, PCb, PCc: driving portion
PXa, PXb, PXc: pixel
EDa, EDb, EDc: light emitting element
EML, EMLa, EMLb, EMLc: light emitting layer
T1, T2, T3: transistor
110: substrate
111: buffer layer
141: gate insulating film
161: interlayer insulating film
181: planarization film
BML, BMLa, BMLb, BMLc: lower shielding layer
125a, 125b, 125c: lower storage electrode
ACT: semiconductor layer
131a, 131b, 131c: first semiconductor
132a, 132b, 132c: second semiconductor
133a, 133b, 133c: third semiconductor
151, 151-1: scan signal line
171a, 171b, 171c: data line
172, 172v: driving voltage line
173: initialization voltage line
174, 174h: driving low voltage line
Cleda, Cledb, Cledc: light emitting portion capacitor
Cst: storage capacitor
GE, GE1a, GE1b, GE1c: gate electrode
SL: sensing wire

## Claims

1. A light emitting display device, comprising:
a substrate;
a driving element layer on the substrate and including a transistor and a planarization film covering the transistor;
a second electrode on the planarization film and including a contact opening;
a separator on the planarization film and has a reverse-tapered sidewall;
a pixel defining layer including a first opening exposing a portion of the second electrode, a second opening exposing a portion of the separator, and a third opening corresponding to the contact opening of the second electrode; and
a first electrode on the pixel defining layer,
wherein the first electrode is electrically connected to the transistor of the driving element layer through the contact opening of the second electrode and the third opening of the pixel defining layer.

2. The light emitting display device of claim 1, wherein the separator includes an outer portion and an inner portion, and the second opening of the pixel defining layer exposes at least a portion of the outer portion of the separator.

3. The light emitting display device of claim 2, wherein an edge of the first electrode coincides with the outer portion exposed by the second opening in plan view.

4. The light emitting display device of claim 3, wherein all side surfaces of the inner portion are covered by the pixel defining layer.

5. The light emitting display device of claim 4, wherein the inner portion overlaps the first electrode in plan view.

6. The light emitting display device of claim 4 or 5, wherein the separator further includes an additional portion, and the second opening of the pixel defining layer exposes at least a portion of the additional portion.

7. The light emitting display device of claim 6, further comprising an additional electrode formed of a same material as the first electrode,
wherein some of edges of the additional electrode coincide with the additional portion exposed by the second opening in plan view;
optionally wherein remaining ones of the edges of the additional electrode coincide with a portion of the outer portion in plan view;
optionally wherein a central portion of the additional electrode excluding the edges overlaps the pixel defining layer in plan view.

8. The light emitting display device of claim 6 or 7, wherein both sidewalls of the additional portion overlap the second opening.

9. A light emitting display device, comprising:
a substrate;
a driving element layer on the substrate and including a driving transistor and a planarization film covering the driving transistor;
a second electrode on the planarization film and including a driving gate electrode overlapping opening overlapping a gate electrode of the driving transistor in plan view;
a separator on the planarization film, having a reverse-tapered sidewall, and including an outer portion, an inner portion, and an additional portion;
a pixel defining layer including a first opening exposing a portion of the second electrode and a second opening exposing at least portions of the outer portion and the additional portion of the separator; and
a first electrode and an additional electrode at an upper potion of the pixel defining layer,
wherein an edge of the first electrode coincides with the outer portion exposed by the second opening in plan view.

10. The light emitting display device of claim 9, wherein some of edges of the additional electrode coincide with the additional portion exposed by the second opening in plan view;
optionally wherein the rest of the edges of the additional electrode coincides with a portion of the outer portion in plan view.

11. The light emitting display device of claim 9 or 10, wherein a central portion of the additional electrode excluding the edges overlaps the pixel defining layer in plan view.

12. The light emitting display device of any one of claims 9 to 11, wherein both sidewalls of the additional portion overlap the second opening.

13. The light emitting display device of any one of claims 9 to 12, wherein the separator includes one or more additional portions connected to one outer portion.

14. The light emitting display device of any one of claims 9 to 13, wherein an edge of the first electrode coincides with the outer portion exposed by the second opening in plan view;
, optionally wherein all side surfaces of the inner portion are covered by the pixel defining layer, and the inner portion overlaps the first electrode in plan view.

15. The light emitting display device of any one of claims 9 to 14, wherein the second electrode further includes a contact opening, the pixel defining layer further includes a third opening corresponding to the contact opening of the second electrode, and the first electrode is electrically connected to the transistor of the driving element layer through the contact opening of the second electrode and the third opening of the pixel defining layer;
optionally wherein the driving gate electrode overlapping opening and the contact opening are integrally formed at the second electrode.
